# EUROPEAN PATENT SPECIFICATION

(11) **EP 2 363 240 B1**
(45) Date of publication and mention of the grant of the patent: **07.03.2018**
(21) Application number: 11000284.7
(22) Date of filing: 14.01.2011
(51) Int. Cl.: B24B 9/06, B24B 21/00

(54) **POLISHING APPARATUS, POLISHING METHOD AND PRESSING MEMBER FOR PRESSING A POLISHING TOOL**
VORRICHTUNG UND VERFAHREN ZUM POLIEREN EINES WERKSTÜCKS, SOWIE ANDRÜCKELEMENT FÜR DAS WERKZEUG
APPAREIL ET PROCÉDÉ DE POLISSAGE AINSI QUE ÉLÉMENT DE PRESSION POUR L'OUTIL

(30) Priority: 15.01.2010 JP 2010006674; 24.12.2010 JP 2010287242
(43) Date of publication of application: 07.09.2011
(73) Proprietor: EBARA CORPORATION, Ohta-ku, Tokyo (JP)
(72) Inventor: Seki, Masaya, Tokyo (JP); Ito, Kenya, Tokyo (JP); Nakanishi, Masayuki, Tokyo (JP)
(74) Representative: Schmidbauer, Andreas Konrad

(56) References cited:
- EP-A2- 2 067 571
- WO-A1-2005/081301
- US-A1- 2003 139 049

## Description

### BACKGROUND OF THE INVENTION

### Field of the Invention:

The present invention relates to a polishing apparatus and a polishing method for polishing a substrate, such as a semiconductor wafer, and more particularly to a polishing apparatus and a polishing method for polishing a peripheral portion of a substrate using a strip-shaped polishing tool, such as a polishing tape. The present invention also relates to a pressing member for pressing the strip-shaped polishing tool against the peripheral portion of the substrate.

### Description of the Related Art:

From a viewpoint of improving yield in fabrication of semiconductor devices, management of surface conditions of a peripheral portion of a substrate has been attracting attention in recent years. In the fabrication process of the semiconductor devices, many materials are deposited on a silicon wafer to form a multilayer structure. Therefore, unwanted films and roughened surface are formed on a peripheral portion of the substrate which is not used for products. It has been a recent trend to transport the substrate by holding only its peripheral portion using arms. Under such circumstances, the unwanted films remaining on the peripheral portion would be peeled off during various processes and could adhere to devices, causing lowered yield. Thus, a polishing apparatus for polishing the peripheral portion of the substrate has been used in order to remove the unwanted films and roughened surface therefrom.

An apparatus using a polishing tape for polishing the peripheral portion of the substrate is known as such a polishing apparatus. This type of polishing apparatus polishes the peripheral portion of the substrate by bringing a polishing surface of the polishing tape in contact with the peripheral portion of the substrate. In this specification, the peripheral portion is defined as a region including a bevel portion which is the outermost portion of the substrate and a top edge portion and bottom edge portion located radially inwardly of the bevel portion.

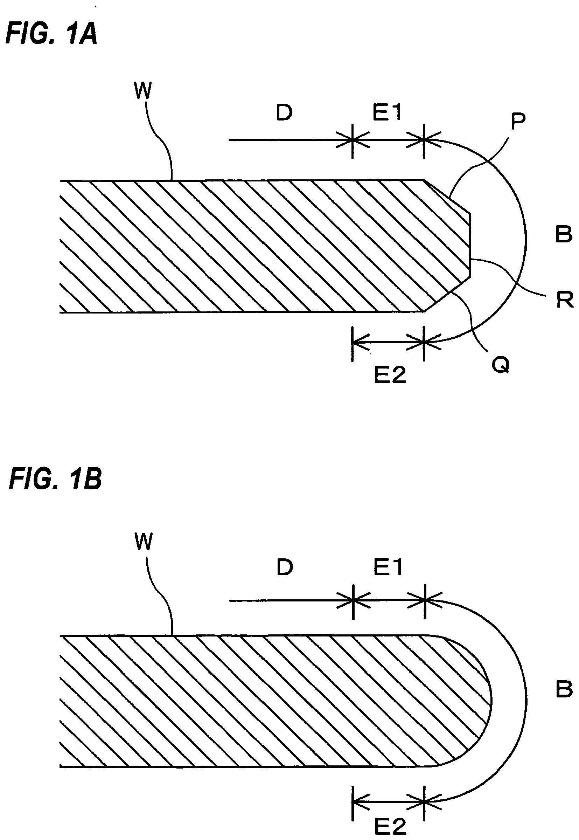

FIG 1A and FIG 1B are enlarged cross-sectional views each showing a peripheral portion of a substrate. More specifically, FIG 1A shows a cross-sectional view of a so-called straight-type substrate, and FIG 1B shows a cross-sectional view of a so-called round-type substrate. In the substrate W shown in FIG 1A, the bevel portion is a portion B that is constituted by an upper slope (an upper bevel portion) P, a lower slope (a lower bevel portion) Q, and a side portion (an apex) R, all of which form an outermost circumferential surface of the substrate W. In the substrate W shown in FIG. 1B, the bevel portion is a portion B having a curved cross section and forming an outermost circumferential surface of the substrate W. The top edge portion is a flat portion E1 located radially inwardly of the bevel portion B and located radially outwardly of a region D where devices are formed. The bottom edge portion is a flat portion E2 located opposite the top edge portion and located radially inwardly of the bevel portion B. These top edge portion E1 and bottom edge portion E2 may be collectively referred to as nearedge portions.

In the conventional polishing apparatus, the polishing tape is pressed by a polishing head against the peripheral portion of the substrate to thereby polish the peripheral portion (for example, see JP 2009 154 285 A). The polishing head has a flat pressing surface, which presses the polishing tape against the peripheral portion of the substrate, while the polishing head is inclined, to thereby polish the peripheral portion. However, it is difficult to accurately polish the top edge portion and the bottom edge portion by the flat pressing surface. For example, in the substrate shown in FIG 1A; it is difficult to polish only the top edge portion E1 accurately along a boundary between the device region D and the top edge portion E1. In particular, when the polishing head is inclined such that the polishing tape makes an acute angle with a surface of the substrate, - the devices may be damaged by the polishing tape.

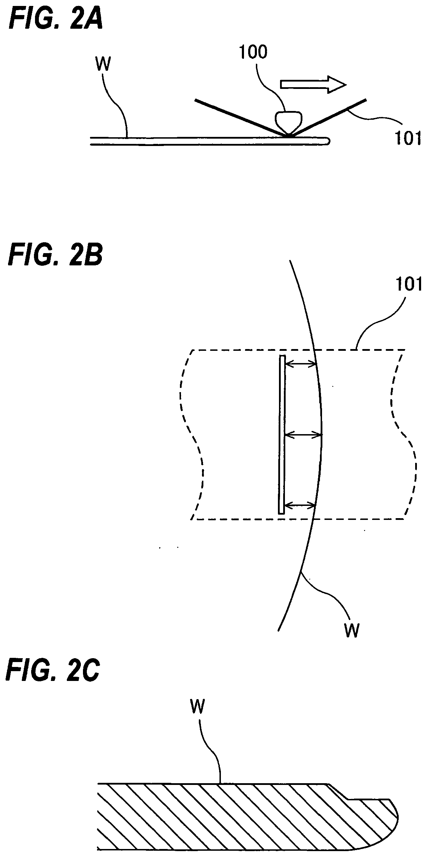

JP 2009 208 214 A discloses a polishing apparatus having linear pressing surface. In this polishing apparatus, as shown in FIG 2A, a pressing member 100 having the linear pressing surface is moved in a radially outward direction of the substrate W at a constant speed, while pressing a polishing tape 101 against the top edge portion of the substrate W. The polishing apparatus thus structured can polish the top edge portion without damaging the device region. However, as shown in FIG 2B, since a distance between the linearly-extending pressing surface and the outermost circumference of the substrate W is not constant, a contact time between the polishing tape and the substrate becomes shorter in an inner edge of the top edge portion than in other regions. As a result, as shown in FIG 2C, the inner edge of the top edge portion is scraped obliquely.

Furthermore, WO 2005 081 301 A1 relates to a polishing apparatus for polishing a peripheral portion of a substrate. The polishing apparatus has a rotational table for holding and rotating the substrate, a polishing tape supply mechanism and a polishing head for pressing the polishing tape against a bevel portion of the substrate. The polishing head has two spaced protrusions, the polishing tape being arranged to span the gap between the protrusions. The polishing head may be positioned that the polishing tape spanning the gap is pressed against the peripheral portion of the substrate. US 2003 139 049 A1 relates to another polishing apparatus for polishing a periphery of a substrate. The polishing apparatus inter alia has a V-shaped structure for guiding a polishing tape to be stretched around the periphery in an in-plane direction of the substrate so that a polishing face of the polishing member may be slid on a polishing target surface of the periphery.

### SUMMARY OF THE INVENTION

The present invention has been made in view of the above drawbacks. It is therefore an object of the present invention to provide a polishing apparatus capable of polishing a top edge portion and/or a bottom edge portion of a substrate accurately and uniformly. Further, another object of the present invention is to provide a polishing method using such a polishing apparatus and to provide a pressing member for pressing a polishing tool used in the polishing apparatus.

In order to achieve the above object, in accordance with the present invention, an apparatus as set forth in claim 1 is provided. Further embodiments are inter alia disclosed in the dependent claims. The apparatus includes: a rotary holding mechanism configured to hold the substrate horizontally and to rotate the substrate; and at least one polishing head disposed near the peripheral portion of the substrate. The polishing head has at least one protrusion for pressing a strip shaped polishing tool against the peripheral portion of - the substrate, said protrusion having a circular arc shape extending along a circumferential direction of the substrate, and wherein the polishing head is configured to press a polishing surface of a strip-shaped polishing tool by the protrusion against the peripheral portion of the substrate from above or below.

In a preferred aspect of the present invention, the polishing apparatus further includes at least one tilting mechanism configured to tilt the polishing head with respect to a surface of the substrate. The at least one protrusion comprises a first protrusion and a second protrusion that are symmetrically arranged. The first protrusion is located above the peripheral portion of the substrate when the polishing head is tilted upward, and the second protrusion is located below the peripheral portion of the substrate when the polishing head is tilted downward.

In a preferred aspect of the present invention, the first protrusion presses the polishing tool against a top edge portion of the substrate, and the second protrusion presses the polishing tool against a bottom edge portion of the substrate.

In a preferred aspect of the present invention, the at least one polishing head comprises plural polishing heads arranged around the substrate, and the at least one tilting mechanism comprises plural tilting mechanisms configured to tilt the plural polishing heads independently.

In a preferred aspect of the present invention, the polishing head further has a pressing pad configured to press the polishing tool against the peripheral portion of the substrate, and the pressing pad is disposed between the first protrusion and the second protrusion.

In a preferred aspect of the present invention, a height of the pressing pad is lower than a height of the first protrusion and the second protrusion.

In a preferred aspect of the present invention, the polishing head further has a pressing pad configured to press the polishing tool against the peripheral portion of the substrate, and the pressing pad is adjacent to the protrusion.

In a preferred aspect of the present invention, a length of the protrusion is longer than a width of the polishing tool.

In a preferred aspect of the present invention, the polishing head includes two guide rollers that support the polishing surface of the polishing tool and further includes an actuator coupled to the two guide rollers and the protrusion. The protrusion is interposed between the two guide rollers, and the actuator is configured to move the two guide rollers and the protrusion in unison toward the peripheral portion of the substrate.

In a preferred aspect of the present invention, the strip-shaped polishing tool is a polishing tape or a polishing cloth.

Another aspect of the present invention provides a polishing apparatus for polishing a peripheral portion of a substrate. The apparatus includes: a rotary holding mechanism configured to hold the substrate horizontally and to rotate the substrate; a polishing head disposed near the peripheral portion of the substrate; and a tilting mechanism configured to tilt the polishing head with respect to a surface of the substrate. The polishing head has a first protrusion and a second protrusion extending along a circumferential direction of the substrate and further has a pressing pad disposed between the first protrusion and the second protrusion. The polishing head is configured to press a polishing surface of a strip-shaped polishing tool by the first protrusion against the peripheral portion of the substrate from above, to press the polishing surface of the polishing tool by the second protrusion against the peripheral portion of the substrate from below, and to press the polishing surface of the polishing tool by the pressing pad against the peripheral portion of the substrate.

Still another aspect of the present invention provides a polishing method using the above-described polishing apparatus. The method includes: rotating a substrate by the rotary holding mechanism; pressing the polishing tool by the first protrusion against a peripheral portion of the substrate from above to thereby polish a top edge portion of the substrate; and pressing the polishing tool by the second protrusion against the peripheral portion of the substrate from below to thereby polish a bottom edge portion of the substrate.

Still another aspect of the present invention provides a polishing method using the above-described polishing apparatus. The method includes: rotating a substrate by the rotary holding mechanism; pressing the polishing tool by the first protrusion against a peripheral portion of the substrate from above to thereby polish a top edge portion of the substrate; pressing the polishing tool by the second protrusion against the peripheral portion of the substrate from below to thereby polish a bottom edge portion of the substrate; and pressing the polishing tool by the pressing pad against the peripheral portion of the substrate to thereby polish a bevel portion of the substrate.

Still another aspect of the present invention provides a polishing method using the above-described polishing apparatus. The method includes: rotating a substrate by the rotary holding mechanism; pressing a strip-shaped polishing tool by a first polishing head against a peripheral portion of the substrate from above to thereby polish a top edge portion of the substrate; pressing the strip-shaped polishing tool by the first polishing head against the peripheral portion of the substrate from below to thereby polish a bottom edge portion of the substrate; and during polishing of the bottom edge portion by the first polishing head, pressing a strip-shaped polishing tool by a second polishing head against the peripheral portion of the substrate from above to thereby polish the top edge portion.

Still another aspect of the present invention provides a polishing method using the above-described polishing apparatus. The method includes: rotating a substrate by the rotary holding mechanism; pressing a strip-shaped polishing tool by a first polishing head against a peripheral portion of the substrate from above to thereby polish a top edge portion of the substrate; and pressing a strip-shaped polishing tool by a second polishing head against the peripheral portion of the substrate from below to thereby polish a bottom edge portion of the substrate.

Still another aspect of the present invention provides a pressing member for pressing a strip-shaped polishing tool against a peripheral portion of a substrate. The pressing member includes at least one protrusion for pressing the strip shaped polishing tool against the peripheral portion of the substrate, the at least one protrusion having a circular arc shape extending along a circumferential direction of the substrate.

According to the present invention, the protrusion presses the polishing tool (e.g., polishing tape) against the peripheral portion of the substrate. Therefore, the polishing tool can accurately polish the peripheral portion without contacting regions other than the peripheral portion. Further, because the protrusion is curved along the circumferential direction of the substrate, the contact time between the substrate and the polishing tool is uniform over polishing region in its entirety. Therefore, it is possible to uniformly polish the entire polishing region including the inner edge of the peripheral portion of the substrate.

### BRIEF DESCRIPTION OF THE DRAWINGS

FIG 1 and FIG 1B are enlarged cross-sectional views each showing a periphery of a substrate;
FIG 2A is a side view showing a part of a conventional polishing apparatus;
FIG 2B is a plan view showing a positional relationship between a pressing surface and a substrate;
FIG 2C is a schematic view showing a cross section of the peripheral portion of the substrate that has been polished by the polishing apparatus shown in FIG 2A;
FIG 3 is a plan view showing a polishing apparatus according to an embodiment of the present invention;
FIG 4 is a vertical cross-sectional view of the polishing apparatus shown in FIG 3;
FIG 5 is an enlarged view of a polishing head;
FIG 6 is a front view of a pressing member shown in FIG 5;
FIG 7 is a rear view of the pressing member shown in FIG 6;
FIG 8 is a left-side view of the pressing member shown in FIG 6;
FIG 9 is a right-side view of the pressing member shown in FIG 6;
FIG 10 is a top view of the pressing member shown in FIG 6;
FIG 11 is a bottom view of the pressing member shown in FIG 6;
FIG 12 is a cross-sectional view taken along line A-A in FIG 6;
FIG 13 is an enlarged view of protrusions shown in FIG 12;
FIG 14 is a view showing the polishing head inclined upward by a tilting mechanism;
FIG 15 is a view showing the polishing head inclined downward by the tilting mechanism;
FIG 16A is a plan view showing a manner in which the upper protrusion brings a polishing tape in contact with a top edge portion of the substrate;
FIG 16B is a schematic view showing a cross section of the peripheral portion of the substrate that has been polished;
FIG 17 is a view showing another example of the polishing head;
FIG 18 is a plan view showing an example of the polishing apparatus having a single polishing head assembly and a single polishing-tape supply mechanism;
FIG 19 is a side view showing the polishing head having a single protrusion arranged so as to face the top edge portion of the substrate;
FIG 20 is a front view of a pressing member shown in FIG 19;
FIG 21 is a rear view of the pressing member shown in FIG 20;
FIG 22 is a left-side view of the pressing member shown in FIG 20;
FIG 23 is a right-side view of the pressing member shown in FIG 20;
FIG 24 is a top view of the pressing member shown in FIG 20;
FIG 25 is a bottom view of the pressing member shown in FIG 20;
FIG 26 is a cross-sectional view taken along line B-B in FIG. 20;
FIG 27 is a side view showing the polishing head having a single protrusion arranged so as to face a bottom edge portion of the substrate;
FIG 28 is a front view showing still another example of the pressing member;
FIG 29 is a rear view of the pressing member shown in FIG 28;
FIG 30 is a left-side view of the pressing member shown in FIG 28;
FIG 31 is a right-side view of the pressing member shown in FIG 28;
FIG 32 is a top view of the pressing member shown in FIG 28;
FIG 33 is a bottom view of the pressing member shown in FIG 28;
FIG 34 is a cross-sectional view taken along line C-C in FIG 28;
FIG 35 is an enlarged view of a press pad and protrusions shown in FIG 34;
FIG 36 is a view showing the polishing head inclined upward by the tilting mechanism;
FIG 37 is a view showing the polishing head inclined downward by the tilting mechanism;
FIG 38 is a view showing the polishing head in a horizontal position;
FIG 39 is a view showing the polishing head inclined upward when polishing the bevel portion of the substrate;
FIG 40 is a view showing the polishing head inclined downward when polishing the bevel portion of the substrate;
FIG 41 is a view showing a manner in which a tilt angle of the polishing head is changed continuously when polishing the bevel portion of the substrate;
FIG 42 is a front view of a pressing member having a pressing pad adjacent to the protrusion for pressing the top edge portion of the substrate;
FIG 43 is a top view of the pressing member shown in FIG 42;
FIG 44 is a front view of a pressing member having a pressing pad adjacent to the protrusion for pressing the bottom edge portion of the substrate; and
FIG 45 is a top view of the pressing member shown in FIG 44.

### DETAILED DESCRIPTION OF THE PREFERRED EMBODIMENTS

Embodiments of the present invention will be described below with reference to the drawings.

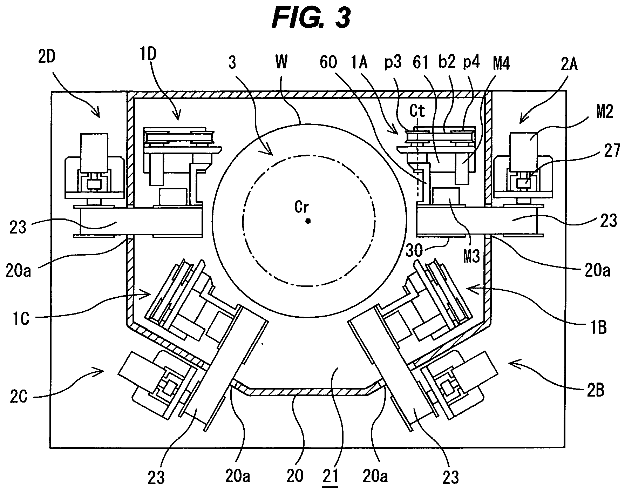

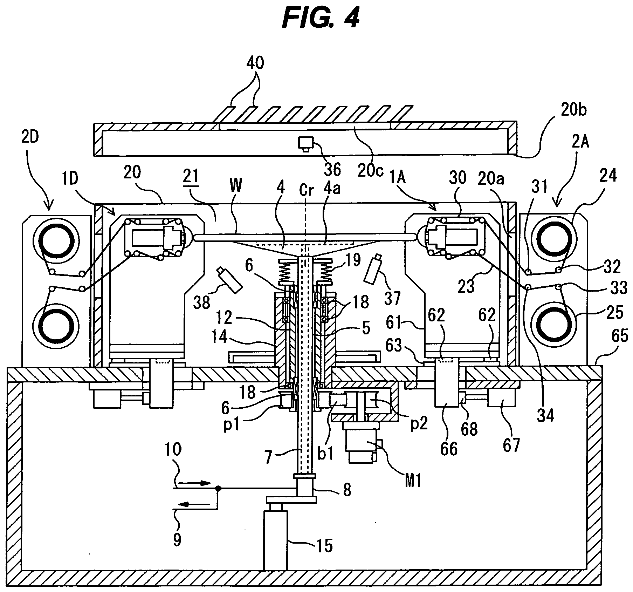

FIG 3 is a plan view showing a polishing apparatus according to an embodiment of the present invention. FIG 4 is a vertical cross-sectional view of the polishing apparatus shown in FIG 3. As shown in FIG 3 and FIG 4, the polishing apparatus includes a rotary holding mechanism (a substrate holder) 3 configured to hold a substrate W (i.e., a workpiece to be polished) horizontally and to rotate the substrate W. The rotary holding mechanism 3 is located in the center of the polishing apparatus. FIG 3 shows a state in which the rotary holding mechanism 3 holds the substrate W. This rotary holding mechanism 3 has a dish-shaped holding stage 4 configured to hold a rear surface of the substrate W by a vacuum suction, a hollow shaft 5 coupled to a central portion of the holding stage 4, and a motor M1 for rotating the hollow shaft 5. The substrate W is placed onto the holding stage 4 by hands of a transporting mechanism (not shown) such that a center of the substrate W is aligned with a central axis of the hollow shaft 5.

The hollow shaft 5 is supported by ball spline bearings (i.e., linear motion bearings) 6 which allow the hollow shaft 5 to move vertically. The holding stage 4 has an upper surface having grooves 4a. These grooves 4a communicate with a communication passage 7 extending through the hollow shaft 5. The communication passage 7 is coupled to a vacuum line 9 via a rotary joint 8 provided on a lower end of the hollow shaft 5. The communication passage 7 is also coupled to a nitrogen-gas supply line 10 for use in releasing the substrate W from the holding stage 4 after processing. By selectively coupling the vacuum line 9 and the nitrogen-gas supply line 10 to the communication passage 7, the substrate W can be held on the upper surface of the holding stage 4 by the vacuum suction and can be released from the upper surface of the holding stage 4.

A pulley p1 is coupled to the hollow shaft 5, and a pulley p2 is mounted on a rotational shaft of the motor M1. The hollow shaft 5 is rotated by the motor M1 through the pulley p1, the pulley p2, and a belt b1 riding on these pulleys p1 and p2. With these structures, the substrate W, held on the upper surface of the holding stage 4, is rotated by the motor M1.

The ball spline bearing 6 is a bearing that allows the hollow shaft 5 to move freely in its longitudinal direction. The ball spline bearings 6 are secured to a cylindrical casing 12. Therefore, the hollow shaft 5 can move linearly up and down relative to the casing 12, and the hollow shaft 5 and the casing 12 rotate in unison. The hollow shaft 5 is coupled to an air cylinder (elevating mechanism) 15, so that the hollow shaft 5 and the holding stage 4 are elevated and lowered by the air cylinder 15.

A cylindrical casing 14 is provided so as to surround the casing 12 in a coaxial arrangement. Radial bearings 18 are provided between the casing 12 and the casing 14, so that the casing 12 is rotatably supported by the radial bearings 18. With these structures, the rotary holding mechanism 3 can rotate the substrate W about its central axis Cr and can elevate and lower the substrate W along the central axis Cr.

As shown in FIG 3, four polishing head assemblies (polishing units) 1A, 1B, 1C, and 1D are arranged around the substrate W held by the rotary holding mechanism 3. Polishing-tape supply mechanisms 2A, 2B, 2C, and 2D are provided radially outwardly of the polishing head assemblies 1A, 1B, 1C, and ID, respectively. The polishing head assemblies 1A, 1B, 1C, and 1D are isolated from the polishing-tape supply mechanisms 2A, 2B, 2C, and 2D by a partition 20. An interior space of the partition 20 provides a polishing room 21. The four polishing head assemblies 1A, 1B, 1C, and 1D and the holding stage 4 are located in the polishing room 21. On the other hand, the polishing-tape supply mechanisms 2A, 2B, 2C, and 2D are located outside the partition 20 (i.e., outside the polishing room 21). The polishing head assemblies 1A, 1B, 1C, and 1D have the same structure, and the polishing-tape supply mechanisms 2A, 2B, 2C, and 2D also have the same structure. Hereinafter, the polishing head assembly 1A and the polishing-tape supply mechanism 2A will be described.

The polishing-tape supply mechanism 2A has a supply reel 24 for supplying a polishing tape 23 to the polishing head assembly 1A, and a recovery reel 25 for recovering the polishing tape 23 that has been used in polishing of the substrate W. The supply reel 24 is arranged above the recovery reel 25. Motors M2 are coupled to the supply reel 24 and the recovery reel 25, respectively, via couplings 27 (FIG 3 shows only the coupling 27 and the motor M2 coupled to the supply reel 24). Each of the motors M2 is configured to exert a constant torque in a predetermined rotational direction so as to apply a predetermined tension to the polishing tape 23.

The polishing tape 23 is a long strip-shaped polishing tool, and one of surfaces thereof provides a polishing surface. The polishing tape 23 includes a base tape made from PET sheet or the like and a polishing layer formed on the base tape. The polishing layer comprises a binder (e.g., resin) covering one surface of the base tape and abrasive grains bound by the binder. A surface of the polishing layer provides the polishing surface. Instead of the polishing tape, a strip-shaped polishing cloth may be used as the polishing tool.

The polishing tape 23 is wound on the supply reel 24, which is mounted on the polishing-tape supply mechanism 2A. Side surfaces of the wound polishing tape 23 are supported by reel plates so that the wound polishing tape 23 does not collapse. One end of the polishing tape 23 is attached to the recovery reel 25. The recovery reel 25 takes up the polishing tape 23 that has been supplied to the polishing head assembly 1A to thereby recover the polishing tape 23. The polishing head assembly 1A has a polishing head 30 for pressing the polishing tape 23, supplied from the polishing-tape supply mechanism 2A, against a peripheral portion of the substrate W. The polishing tape 23 is supplied to the polishing head 30 such that the polishing surface of the polishing tape 23 faces the substrate W.

The polishing-tape supply mechanism 2A has plural guide rollers 31, 32, 33, and 34. The polishing tape 23, to be supplied to and recovered from the polishing head assembly 1A, is guided by these guide rollers 31, 32, 33, and 34. The polishing tape 23 is supplied to the polishing head 30 from the supply reel 24 through an opening 20a formed in the partition 20, and the polishing tape 23 that has been used in polishing of the substrate is recovered by the recovery reel 25 through the opening 20a.

As shown in FIG 4, an upper supply nozzle 36 is provided above the substrate W. This upper supply nozzle 36 is configured to supply a polishing liquid onto a center of an upper surface of the substrate W held by the rotary holding mechanism 3. Further, a lower supply nozzle 37 is provided for supplying a polishing liquid onto a boundary between the rear surface of the substrate W and the holding stage 4 (i.e., onto a peripheral portion of the holding stage 4). Typically, pure water is used as the polishing liquid. In a case of using silica as the abrasive grains of the polishing tape 23, ammonia may be used as the polishing liquid. The polishing apparatus further includes a cleaning nozzle 38 for cleaning the polishing head 30 after the polishing process. The substrate W is elevated by the rotary holding mechanism 3 after the polishing process, and then the cleaning nozzle 38 ejects cleaning water toward the polishing head 30, whereby the polishing head 30 is cleaned after the polishing process.

In order to isolate mechanical devices, such as the ball spline bearings 6 and the radial bearings 18, from the polishing room 21 when the hollow shaft 5 is elevated and lowered relative to the casing 12, the hollow shaft 5 and an upper end of the casing 12 are coupled to each other by a bellows 19 that is extensible and contractible in a vertical direction, as shown in FIG 4. FIG 4 shows a state in which the hollow shaft 5 is in a lowered position and the holding stage 4 is in a polishing position. After the polishing process, the air cylinder 15 elevates the substrate W, together with the holding stage 4 and the hollow shaft 5, to a transport position, where the substrate W is released from the holding stage 4.

The partition 20 has an entrance 20b through which the substrate W is transported into and removed from the polishing room 21. The entrance 20b is a horizontally extending cutout. Therefore, the substrate W, held by the transporting mechanism, can travel horizontally across the polishing room 21 through the entrance 20b. An upper surface of the partition 20 has an aperture 20c and louvers 40, and a lower surface of the partition 20 has a gas-discharge opening (not shown in the drawing). During the polishing process, the entrance 20b is closed by a non-illustrated shutter. Therefore, as a fan mechanism (not shown in the drawing) is driven to evacuate an air through the gas-discharge opening, downward flow of clean air is formed in the polishing room 21. Because the polishing process is performed under such conditions, the polishing liquid is prevented from scattering upwardly. Therefore, the polishing process can be performed while an upper space of the polishing room 21 is kept clean.

As shown in FIG 3, the polishing head 30 is secured to one end of an arm 60, which is rotatable about an axis Ct extending parallel to a tangential direction of the substrate W. The other end of the arm 60 is coupled to a motor M4 via pulleys p3 and p4 and a belt b2. As the motor M4 rotates in a clockwise direction and a counterclockwise direction through a certain angle, the arm 60 rotates about the axis Ct through a certain angle. In this embodiment, the motor M4, the arm 60, the pulleys p3 and p4, and the belt b2 constitute a tilting mechanism for tilting the polishing head 30 with respect to the surface of the substrate W.

The tilting mechanism is mounted on a movable base 61. This movable base 61 is movably coupled to a base plate 65 via guides 62 and rails 63. The rails 63 extend linearly in a radial direction of the substrate W held on the rotary holding mechanism 3, so that the movable base 61 can move linearly in the radial direction of the substrate W. A connection plate 66, extending through the base plate 65, is secured to the movable base 61. A linear actuator 67 is coupled to the connection plate 66 via a joint 68. This linear actuator 67 is secured to the base plate 65 directly or indirectly.

The linear actuator 67 may comprise an air cylinder or a combination of a positioning motor and a ball screw. The linear actuator 67, the rails 63, and the guides 62 constitute a moving mechanism for linearly moving the polishing head 30 in the radial direction of the substrate W. Specifically, the moving mechanism is operable to move the polishing head 30 closer to and away from the substrate W along the rails 63. On the other hand, the polishing-tape supply mechanism 2A is fixed to the base plate 65.

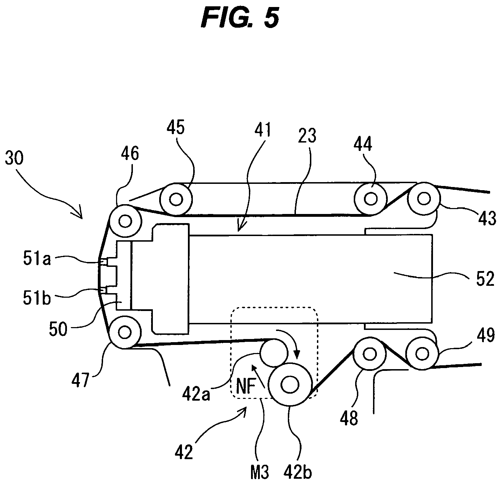

FIG 5 is an enlarged view of the polishing head 30. As shown in FIG 5, the polishing head 30 has a pressing mechanism 41 configured to press the polishing surface of the polishing tape 23 against the substrate W at predetermined force. The polishing head 30 further has a tape-sending mechanism 42 configured to send the polishing tape 23 from the supply reel 24 to the recovery reel 25. The polishing head 30 has plural guide rollers 43, 44, 45, 46, 47, 48, and 49, which guide the polishing tape 23 such that the polishing tape 23 travels in a direction perpendicular to the tangential direction of the substrate W.

The tape-sending mechanism 42 of the polishing head 30 includes a tape-sending roller 42a, a tape-holding roller 42b, and a motor M3 configured to rotate the tape-sending roller 42a. The motor M3 is mounted on a side surface of the polishing head 30. The tape-sending roller 42a is mounted to a rotational shaft of the motor M3. The tape-holding roller 42b is adjacent to the tape-sending roller 42a. The tape-holding roller 42b is supported by a non-illustrated mechanism, which biases the tape-holding roller 42b in a direction indicated by arrow NF in FIG 5 (i.e., in a direction toward the tape-sending roller 42a) so as to press the tape-holding roller 42b against the tape-sending roller 42a.

As the motor M3 rotates in a direction indicated by arrow in FIG 5, the tape-sending roller 42a is rotated to send the polishing tape 23 from the supply reel 24 to the recovery reel 25 via the polishing head 30. The tape-holding roller 42b is configured to be rotatable freely about its own axis and is rotated as the polishing tape 23 is sent.

The pressing mechanism 41 includes a pressing member 50 located at the rear side of the polishing tape 23 and an air cylinder (an actuator) 52 configured to move the pressing member 50 toward the peripheral portion of the substrate W. The air cylinder 52 is a so-called single rod cylinder. The force of the pressing member 50 that presses the polishing tape 23 against the substrate W is regulated by controlling air pressure supplied to the air cylinder 52. The four polishing head assemblies 1A, 1B, 1C, and 1D arranged around the substrate W have the tilting mechanisms, the pressing mechanisms 41, the tape-sending mechanisms 42, and the polishing-head moving mechanisms, which are capable of operating independently.

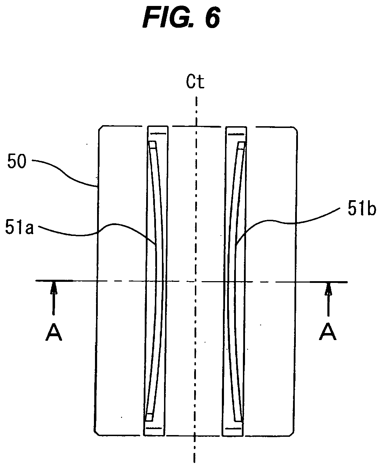

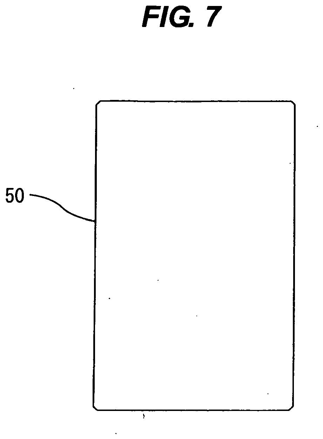

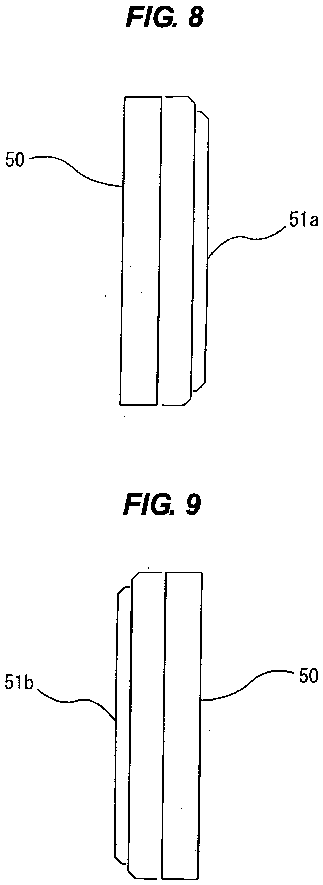

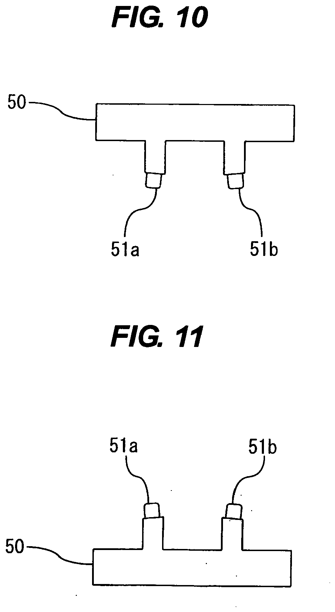

FIG 6 through FIG 11 are front, rear, left-side, right-side, top, and bottom views of the pressing member shown in FIG 5. As shown in FIG 6 through FIG 11, the pressing member 50 has two protrusions 51a and 51b formed on a front surface thereof. These protrusions 51a and 51b are in a shape of rail and are arranged in parallel. The protrusions 51a and 51b are curved along the circumferential direction of the substrate W. More specifically, the protrusions 51a and 51b have a circular arc shape whose curvature is substantially the same as a curvature of the substrate W. The two protrusions 51a and 51b are symmetrical about the rotational axis Ct. As shown in FIG 6, the protrusions 51a and 51b are curved inwardly toward the rotational axis Ct as viewed from a front of the pressing member 50. The polishing head 30 is disposed such that a center line (i.e., the rotational axis Ct) extending between tip ends of the protrusions 51a and 51b coincides with a center of a thickness of the substrate W. The protrusions 51a and 51b are arranged such that the protrusions 51a and 51b are closer to the substrate W than the guide rollers 46 and 47 that are disposed at the front of the polishing head 30, so that the polishing tape 23 is supported from the rear side thereof by the protrusions 51a and 51b. The protrusions 51a and 51b are made from resin, such as PEEK (polyetheretherketone).

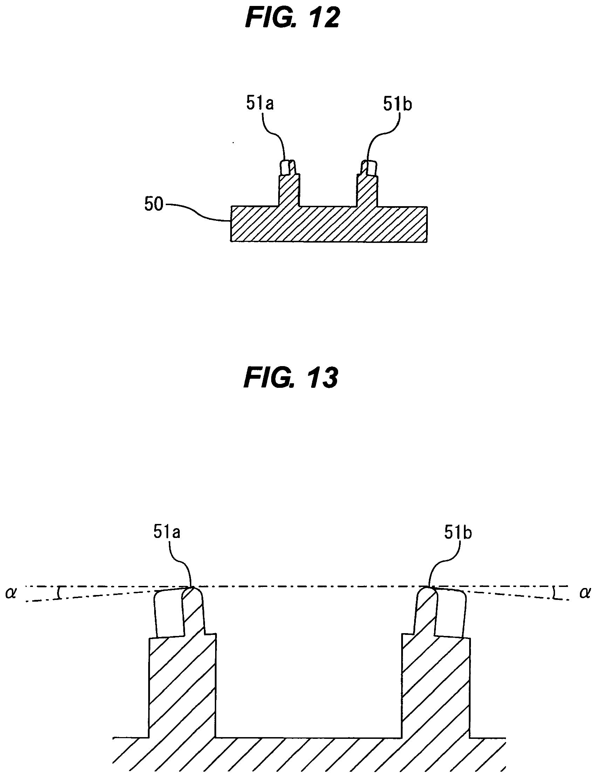

FIG 12 is a cross-sectional view taken along line A-A in FIG 6. FIG. 13 is an enlarged view of the protrusions shown in FIG 12. The protrusions 51a and 51b have pressing surfaces, respectively, for pressing the polishing tape 23 against the substrate W. Each pressing surface has a rounded cross section. The entire pressing surface of the protrusion 51a is slightly inclined with respect to the polishing tape 23 extending between the protrusion 51a and the protrusion 51b. Similarly, the entire pressing surface of the protrusion 51b is slightly inclined with respect to the polishing tape 23 extending between the protrusion 51a and the protrusion 51b. In FIG. 13, an angle of the pressing surface with respect to the polishing tape 23 is represented by α.

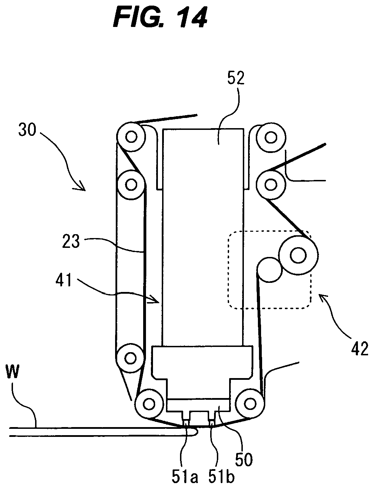

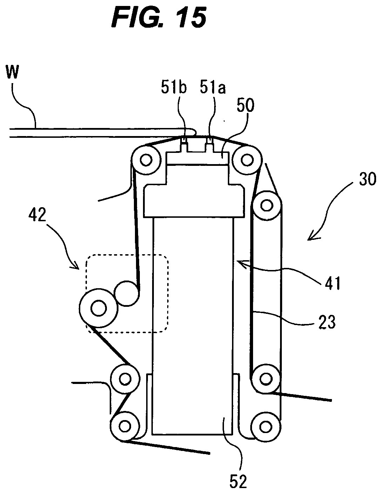

FIG 14 is a view showing the polishing head inclined upward by the tilting mechanism, and FIG 15 is a view showing the polishing head inclined downward by the tilting mechanism. As shown in FIG 14 and FIG. 15, when the polishing head 30 is tilted upward, the upper protrusion (first protrusion) 51a is located above the peripheral portion of the substrate W to face the top edge portion. When the polishing head 30 is tilted downward, the lower protrusion (second protrusion) 51b is located below the peripheral portion of the substrate W to face the bottom edge portion. When polishing the top edge portion, the polishing head 30 is inclined upward and in this sate the protrusion 51a presses the polishing tape 23 against the peripheral portion of the substrate W from above (i.e., against the top edge portion). On the other hand, when polishing the bottom edge portion, the polishing head 30 is inclined downward and in this sate the protrusion 51b presses the polishing tape 23 against the peripheral portion of the substrate W from below (i.e., against the bottom edge portion). Pressing forces of the protrusions 51a and 51b can be regulated by the air cylinder 52.

The tilt angles of the polishing head 30 when polishing the top edge portion and the bottom edge portion are such that the entire pressing surface of the protrusion is parallel to the surface (i.e., the upper surface or the lower surface) of the substrate W. By tilting the polishing head 30 at such angle, the polishing tape 23 extending between the protrusion 51a and the protrusion 51b is separated from the surface of the substrate W, because the pressing surface of each protrusion is inclined as shown in FIG 13. Therefore, the polishing tape 23 is substantially in line contact with the substrate W. In one embodiment, the angle α of the pressing surface shown in FIG 13 is 5 degrees.

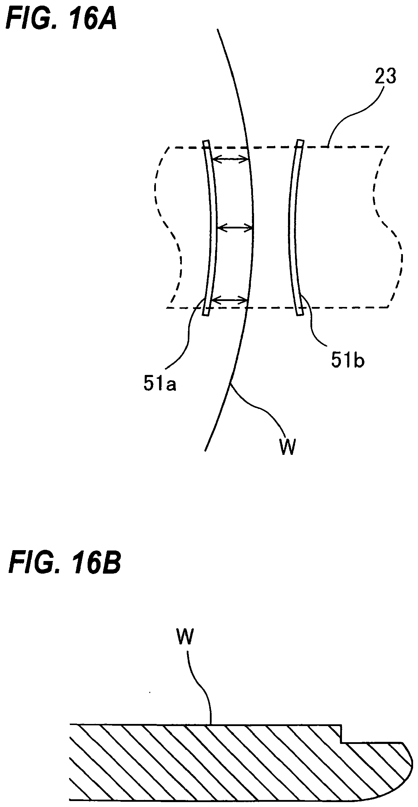

FIG 16A is a plan view showing a manner in which the upper protrusion brings the polishing tape in contact with the top edge portion of the substrate, and FIG 16B is a schematic view showing a cross section of the peripheral portion of the substrate that has been polished. When polishing the top edge portion, the polishing head 30 is tilted upward until the pressing surface of the protrusion 51a is parallel to the upper surface (i.e., the top edge portion) of the substrate W. In this state, the upper protrusion 51a presses the polishing tape 23 against the top edge portion. While pressing the polishing tape 23 against the substrate W, the polishing head 30 is moved in a radially outward direction of the substrate W at a constant speed by the above-described moving mechanism constituted by the linear actuator 67 and other elements.

When the protrusion 51a is pressing the polishing tape 23 against the top edge portion, a polishing width (i.e., a distance between the protrusion 51a and the outermost circumference of the substrate W) is constant throughout the entire length of the protrusion 51a, as shown in FIG 16A. This is because the protrusion 51a is curved along the peripheral portion of the substrate W as viewed from above. Use of such protrusion 51a enables the polishing tape 23 to polish only the top edge portion accurately without damaging the device region (see reference symbol D in FIG 1A and FIG 1B).

The substrate W is polished by sliding contact with the polishing tape 23. Therefore, an amount of film removed by the polishing tape 23 is determined by a cumulative contact time between the substrate W and the polishing tape 23. According to this embodiment of the polishing apparatus, the contact time of the polishing tape 23 with the substrate W is uniform over the top edge portion in its entirety, because the protrusion 51a is curved along the peripheral portion of the substrate W. Therefore, as shown in FIG 16B, the top edge portion in its entirety can be polished uniformly. Further, use of the curved protrusion 51a can provide a longer contact length between the polishing tape 23 and the substrate W, thus increasing a polishing rate.

The upper protrusion 51a and the lower protrusion 51b are symmetrical with respect to the rotational axis Ct. Therefore, as shown in FIG 15, when the polishing head 30 is tilted downward until the lower protrusion 51b faces the bottom edge portion, the protrusion 51b extends along the bottom edge portion of the substrate W. Therefore, the bottom edge portion can be polished accurately and uniformly by the protrusion 51b, as well as the top edge portion.

As shown in FIG 16A, it is preferable that length of the protrusions 51a and 51b be longer than a width of the polishing tape 23. Specifically, it is preferable that the length of the protrusions 51a and 51b be longer than the width of the polishing tape 23 by about 2 mm. In this case, the protrusions 51a and 51b are arranged such that the protrusions 51a and 51b extend beyond both sides of the polishing tape 23 by about 1 mm. As shown in FIG 2B, if the length of the pressing surface of the pressing member 100 is shorter than the width of the polishing tape 101, both side portions of the polishing tape 101 would flutter when the polishing tape 101 is tensioned and may damage the substrate W. According to the embodiment described above, the protrusions 51a and 51b that are longer than the width of the polishing tape 23 are used. As a result, the polishing tape 23 is supported over its full width by the protrusions 51a and 51b, and therefore the polishing tape 23 can be sent stably.

Polishing of the top edge portion is performed as follows. First, the substrate W is rotated about its axis by the rotary holding mechanism 3. Subsequently, the polishing liquid (e.g., pure water) is supplied onto the substrate W from the upper supply nozzle 36 and the lower supply nozzle 37. As shown in FIG 14, the polishing head 30 is inclined upward by the tilting mechanism until the protrusion 51a faces the top edge portion of the substrate W. Then, the polishing tape 23 is pressed against the top edge portion from above by the upper protrusion 51a, while the tape-sending mechanism 42 sends the polishing tape 23 in its longitudinal direction. In this state, the polishing head 30 is moved in the radially outward direction of the substrate W at a constant speed by the linear actuator 67, thereby polishing the top edge portion.

Polishing of the bottom edge portion is performed in the same manner as polishing of the top edge portion. Specifically, the substrate W is rotated about its axis by the rotary holding mechanism 3. Subsequently, the polishing liquid (e.g., pure water) is supplied onto the substrate W from the upper supply nozzle 36 and the lower supply nozzle 37. As shown in FIG 15, the polishing head 30 is inclined downward by the tilting mechanism until the protrusion 51b faces the bottom edge portion of the substrate W. Then, the polishing tape 23 is pressed against the bottom edge portion from below by the lower protrusion 51b, while the tape-sending mechanism 42 sends the polishing tape 23 in its longitudinal direction. In this state, the polishing head 30 is moved in the radially outward direction of the substrate W at a constant speed, thereby polishing the bottom edge portion.

Since the polishing tape 23 is supported by the protrusions 51a and 51b, a space is formed between the polishing tape 23 and the pressing member 50. This space serves as a hole that allows the polishing liquid, that has been supplied to the substrate W, to pass therethrough. Specifically, when the top edge portion and the bottom edge portion are being polished, the polishing liquid is supplied to the rotating substrate W as described above. The polishing liquid on the substrate W is spun off from the substrate W by centrifugal force, and most of the polishing liquid passes through the space between the polishing tape 23 and the pressing member 50 without impinging upon the pressing member 50. In this manner, because the polishing liquid, scattered from the substrate W, hardly impinges upon the pressing member 50, the polishing liquid does not bounce back onto the substrate W. Therefore, contamination of the substrate W due to particles, such as polishing debris, contained in the polishing liquid can be prevented.

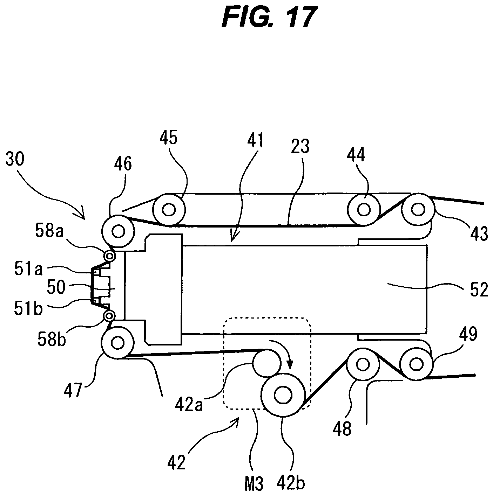

FIG 17 is a view showing another example of the polishing head. Structures and operations of the polishing head that are not described below are identical to those of the polishing head shown in FIG 5 and FIG 6. As shown in FIG 17, two guide rollers 58a and 58b are disposed such that the two protrusions 51a and 51b are interposed therebetween. More specifically, the guide roller 58a is arranged between the upper protrusion 51a and the guide roller 46, and the guide roller 58b is arranged between the lower protrusion 51b and the guide roller 47. The guide rollers 58a and 58b are supported by the pressing member 50, so that the guide rollers 58a and 58b and the protrusions 51a and 51b are moved in unison toward and away from the peripheral portion of the substrate W by the air cylinder 52.

A traveling direction of the polishing tape 23 is guided by the guide roller 46, the guide roller 58a, the protrusions 51a and 51b, the guide roller 58b, and the guide roller 47 in this order. The guide rollers 46 and 47, which are disposed at the front of the polishing head 30, support the rear surface of the polishing tape 23. The guide rollers 58a and 58b, which are coupled to the air cylinder 52, support the polishing surface of the polishing tape 23. The guide rollers 58a and 58b are arranged farther away from the substrate W than the protrusions 51a and 51b so that the guide rollers 58a and 58b do not contact the substrate W. A portion of the polishing tape 23 extending between the guide roller 46 and the protrusion 51a and a portion of the polishing tape 23 extending between the guide roller 47 and the protrusion 51b are guided by the guide rollers 58a and 58b in a direction away from the substrate W. The guide rollers 58a and 58b thus arranged can separate the portions of the polishing tape 23 located at both sides (i.e., upstream side and downstream side) of the protrusions 51a and 51b from the substrate W. Therefore, the polishing tape 23 can be reliably prevented from contacting regions other than the peripheral portion.

Further, the polishing head 30 shown in FIG 17 is advantageous in that, because the guide rollers 58a and 58b are coupled to the air cylinder 52, the pressing force applied to the substrate W is not lowered with the increase in the tension of the polishing tape 23. In the conventional polishing apparatus shown in FIG 2A, when the tension of the polishing tape 101 is increased, a force acts on the pressing member 100 in a direction away from the substrate W. As a result, the pressing force applied to the substrate is reduced and the polishing rate is lowered. In contrast, in the polishing head 30 shown in FIG 17, the guide rollers 58a and 58b, which support the polishing surface of the polishing tape 23, are coupled to the air cylinder 52. According to these arrangements, when the tension of the polishing tape 23 is increased, a force is exerted on the pressing member 50 in a direction toward the substrate W. Therefore, the increase in the tension of the polishing tape 23 does not cause a decrease in the pressing force applied to the substrate W. As a result, the polishing head 30 can polish the peripheral portion of the substrate W at high polishing rate.

As shown in FIG 3, the polishing apparatus according to the embodiment has the multiple polishing head assemblies and multiple polishing-tape supply mechanisms. Therefore, multiple polishing heads 30 can polish the peripheral portion of the substrate W simultaneously. For example, in order to increase the polishing rate, it is possible to polish only the top edge portion or only the bottom edge portion by the plural polishing heads 30 using the same type of polishing tapes. It is also possible to polish the top edge portion by the polishing head assembly 1A and to polish the bottom edge portion by the polishing head assembly 1B simultaneously.

Further, it is possible to polish the top edge portion and the bottom edge portion successively by the plural polishing heads 30. For example, the polishing head assembly 1A presses a polishing tape against the top edge portion of the substrate W to polish the top edge portion, subsequently the polishing head assembly 1A presses the polishing tape against the bottom edge portion of the substrate W to polish the bottom edge portion, and the polishing head assembly 1B presses a polishing tape against the top edge portion of the substrate W to polish the top edge portion during polishing of the bottom edge portion by the polishing head assembly 1A. In this case, different types of polishing tapes can be used in the polishing head assembly 1A and the polishing head assembly 1B. For example, the polishing head assembly 1A may use a polishing tape for rough polishing, and the polishing head assembly 1B may use a polishing tape for finish polishing. According to the above-described embodiment of the polishing apparatus, each polishing head 30 has the two protrusions 51a and 51b, which allow greater flexibility of the polishing process of the peripheral portion of the substrate. Therefore, desired polishing recipes can be used in polishing of the peripheral portion of the substrate.

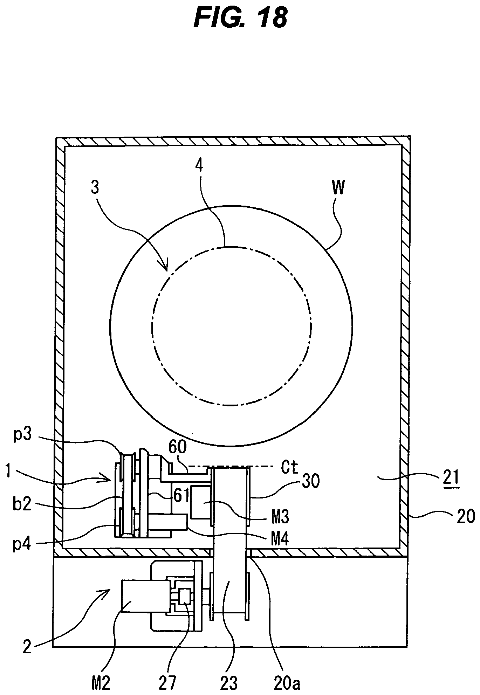

While the polishing apparatus shown in FIG 3 includes the four polishing head assemblies and the four polishing-tape supply mechanisms, the present invention is not limited to this embodiment. For example, two, or three, or more than five sets of polishing head assemblies and polishing-tape supply mechanisms may be provided. Further, as shown in FIG 18, the polishing apparatus may have a single polishing head assembly 1 and a single polishing-tape supply mechanism 2.

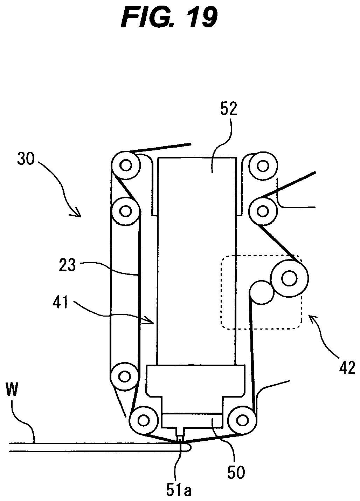

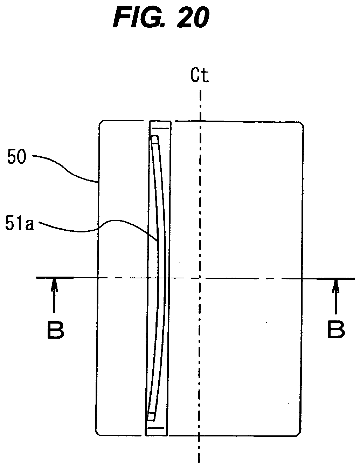

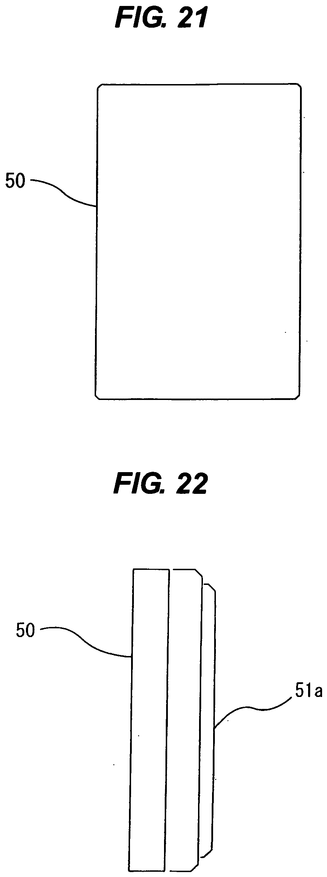

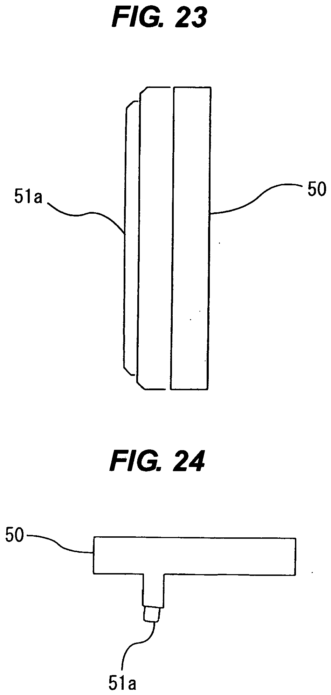

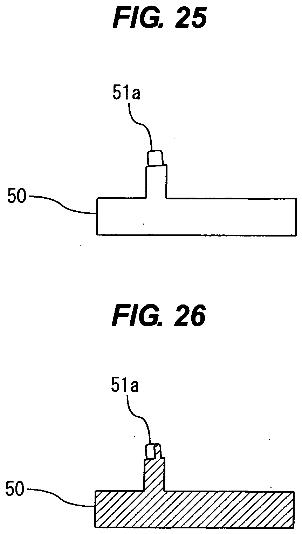

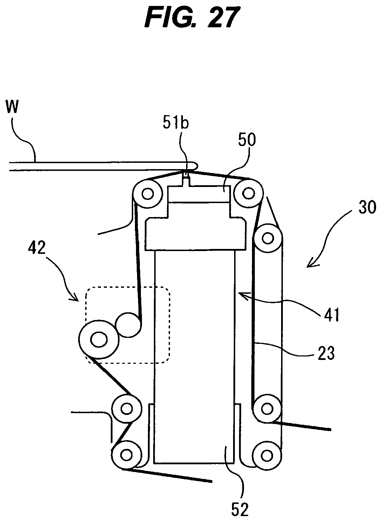

While the two protrusions are provided in the above-described polishing apparatus, only a single protrusion may be provided. FIG 19 is a side view showing the polishing head having a single protrusion arranged so as to face the top edge portion of the substrate. FIG 20 through FIG 25 are front, rear, left-side, right-side, top, and bottom views of a pressing member shown in FIG 19. FIG 26 is a view taken along line B-B shown in FIG 20. FIG 27 is a side view showing the polishing head having a single protrusion arranged so as to face the bottom edge portion of the substrate. In these examples also, the protrusions 51a and 51b are curved along the peripheral portion of the substrate (i.e., along the top edge portion and the bottom edge portion). Front, rear, left-side, right-side, top, and bottom views of a pressing member shown in FIG 27 are substantially identical to the views shown in FIG 20 through FIG 25 and are therefore omitted.

The protrusion 51a shown in FIG 19 is arranged above the peripheral portion of the substrate W and is curved along the top edge portion. Therefore, the protrusion 51a is used only for polishing of the top edge portion and is not used for polishing of the bottom edge portion. On the other hand, the protrusion 51b shown in FIG 27 is arranged below the peripheral portion of the substrate W and is curved along the bottom edge portion. Therefore, the protrusion 51b is used only for the bottom edge portion and is not used for the top edge portion. In these examples, the above-described tilting mechanism may be omitted. In this case, it is preferable that the polishing head assemblies 1A to 1D shown in FIG 2 include the polishing head assembly for polishing the top edge portion and the polishing head assembly for polishing the bottom edge portion. Further, in these examples, the inclination angle α (see FIG 13) of the pressing surfaces of the protrusions 51a and 51b may be zero. In other words, the polishing head 30 may be provided in a position perpendicular to the surface of the substrate W, and the pressing surfaces of the protrusions 51a and 51b may be parallel to the surface of the substrate W.

As shown in FIG 19 and FIG 27, the polishing tape 23 is supported by the protrusion 51a or the protrusion 51b. As a result, a space is formed between the polishing tape 23 and the pressing member 50. Therefore, in these examples also, most of the polishing liquid, that has been spun off from the rotating substrate W, passes through the space between the polishing tape 23 and the pressing member 50 without impinging upon the pressing member 50. In particular, in the examples shown in FIG 19 and FIG 27, the protrusion (51b or 51a) does not exist in a position radially outwardly of the substrate W when polishing the top edge portion and the bottom edge portion. Therefore, the polishing liquid that has been scattered from the substrate W does not impinge upon the pressing member 50. As a result, contamination of the substrate W due to particles, such as polishing debris, contained in the polishing liquid can be prevented.

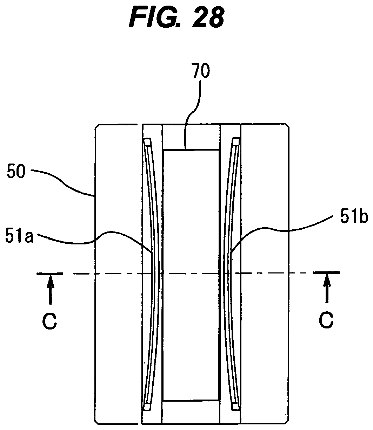

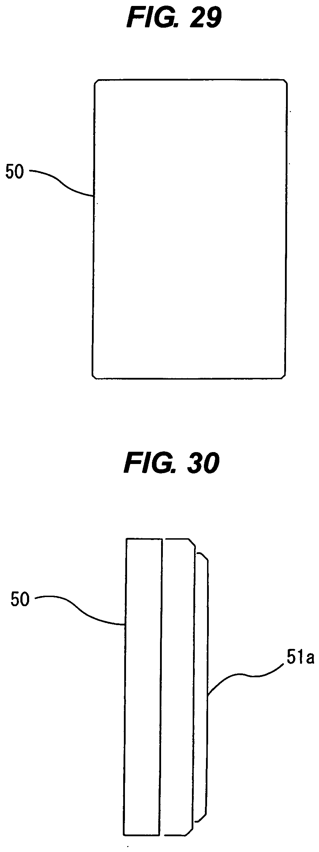

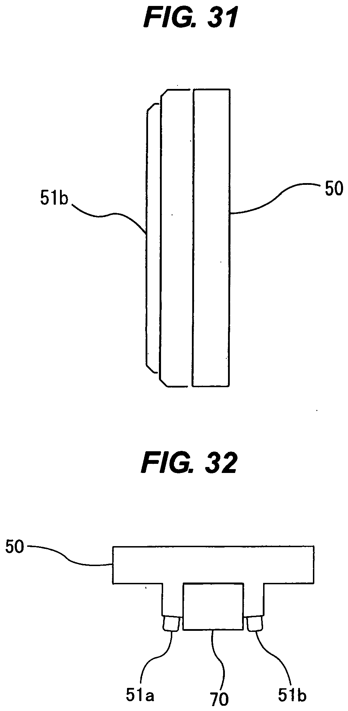

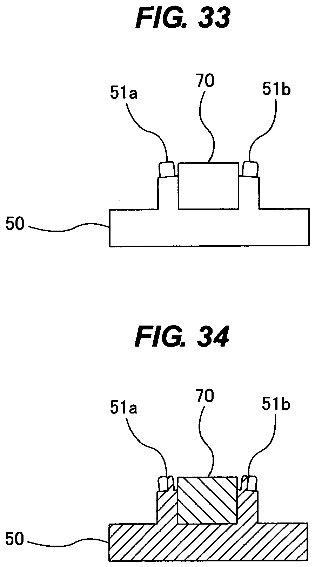

FIG 28 through FIG 33 are front, rear, left-side, right-side, top, and bottom views of still another example of the pressing member 50. FIG 34 is a view taken along line C-C shown in FIG 28. The pressing member 50 shown in FIG 28 through FIG 34 is different from the pressing member 50 shown in FIG 6 through FIG 13 in that a pressing pad (bevel pad) 70 is provided between the two protrusions 51a and 51b. Other structures of the pressing member 50 that are not described below are identical to those of the pressing member 50 shown in FIG 6 through FIG 13 and repetitive descriptions will be omitted.

The pressing pad 70 is located at the center of the pressing member 50. Arrangement of the pressing pad 70 is such that the pressing pad 70 faces the bevel portion (see FIG 1A and FIG IB) of the substrate on the rotary holding mechanism 3 when the polishing head 30 is in a horizontal position. The pressing pad 70 is made from closed-cell foam material (e.g., silicone rubber) having elasticity. When the pressing member 50 is moved toward the substrate by the air cylinder 52 with the polishing head 30 in the horizontal position, the pressing pad 70 presses the polishing tape from the rear side thereof against the bevel portion of the substrate. In order to reduce friction with the rear surface of the polishing tape, a sheet having a Teflon-coated surface may be attached to a front surface (i.e., a pressing surface) of the pressing pad 70. This pressing pad 70 is removably attached by bolts or the like.

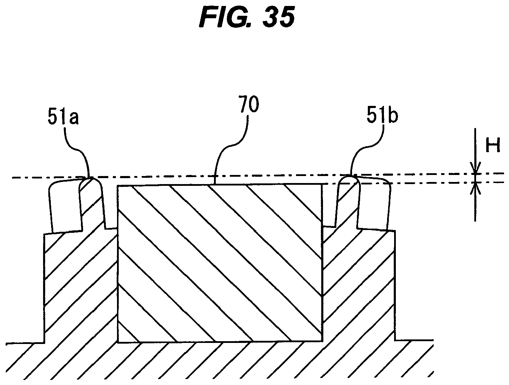

FIG 35 is an enlarged view showing the pressing pad 70 and the protrusions 51a and 51b. As shown in FIG 35, a height of the pressing pad 70 is slightly lower than a height of the protrusions 51a and 51b. This is for preventing the pressing pad 70 from pressing the polishing tape against the substrate when polishing the substrate with the protrusion 51a or the protrusion 51b. A difference in height between the protrusions 51a and 51b and the pressing pad 70 (this difference is indicated by H) is preferably larger than 0 mm and not more than 1 mm.

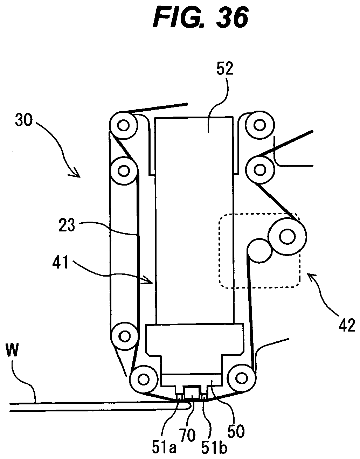

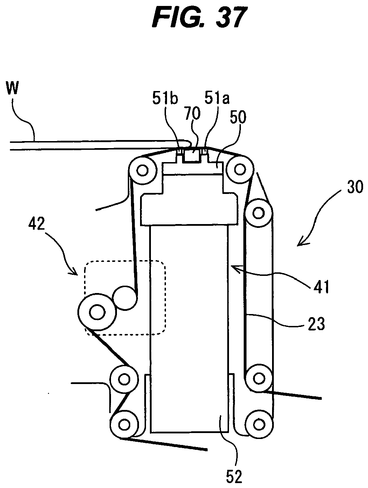

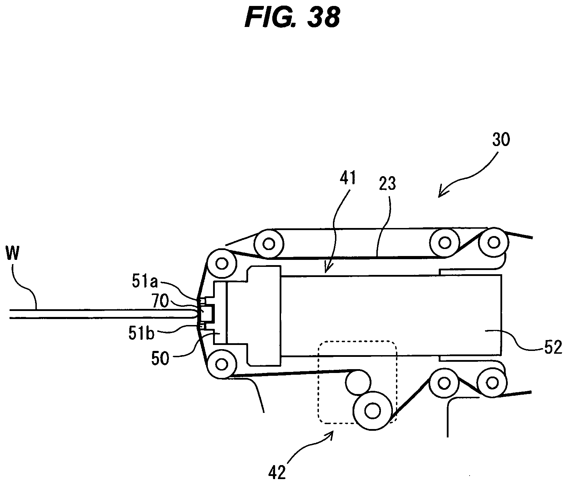

FIG 36 through FIG 38 are views illustrating an example of a polishing method using the polishing head 30 having the pressing member 50 shown in FIG 28. As shown in FIG 36, the polishing head 30 is inclined upward and the polishing tape 23 is pressed by the protrusion 51a against the top edge portion of the substrate W to thereby polish the top edge portion. Subsequently, as shown in FIG 37, the polishing head 30 is inclined downward and the polishing tape 23 is pressed by the protrusion 51b against the bottom edge portion of the substrate W to thereby polish the bottom edge portion. Then the polishing head 30 is put to the horizontal position (i.e., the tilt angle with respect to the surface of the substrate W is zero), and the polishing tape 23 is pressed by the pressing pad 70 against the bevel portion of the substrate W to thereby polish the bevel portion.

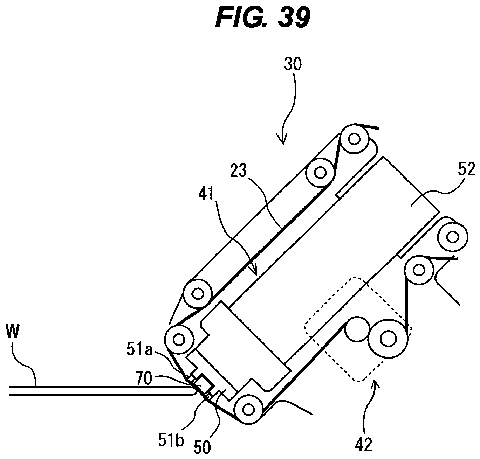

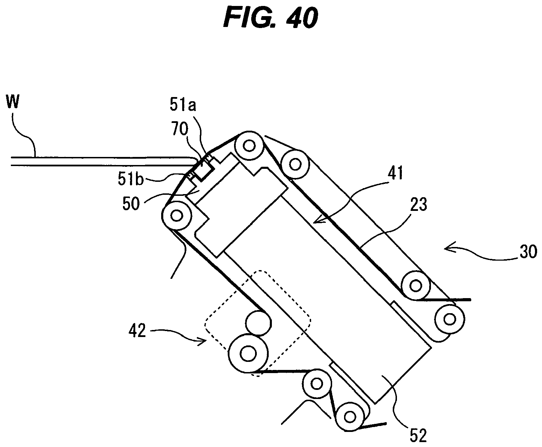

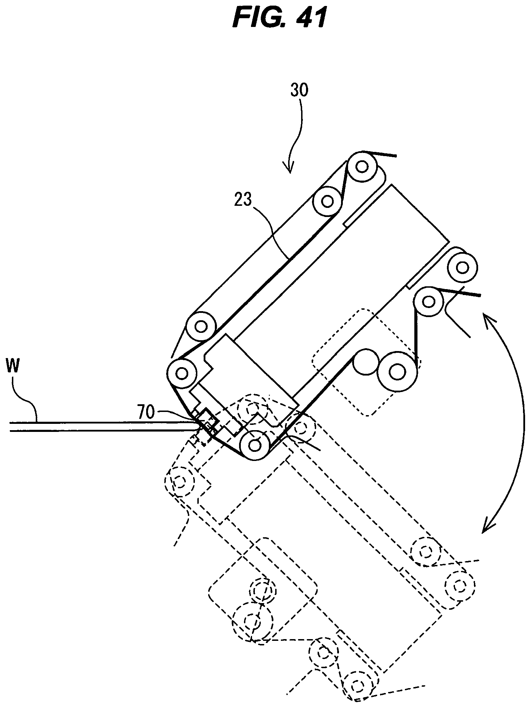

Further, as shown in FIG 39 and FIG 40, the polishing head 30 may be inclined at predetermined angles so that the polishing tape 23 is pressed obliquely against the bevel portion of the substrate W to polish the bevel portion. By tilting the polishing head 30 in this manner, the polishing head 30 can polish the bevel portion in its entirety including the upper slope (upper bevel portion) P, the lower slope (lower bevel portion) Q, and the side portion (apex) R shown in FIG 1A. Further, as shown in FIG 41, the tilt angle of the polishing head 30 may be changed continuously by the tilting mechanism while the pressing pad 70 is pressing the polishing tape 23 against the bevel portion of the substrate W.

In this manner, use of the pressing member 50 having the protrusions 51a and 51b and the pressing pad 70 can enable the polishing tape 23 to polish the peripheral portion of the substrate W in its entirety. Sequence of polishing of the top edge portion, the bevel portion, and the bottom edge portion can be determined from a type, a target shape, and the like of the substrate. Examples of polishing sequence are as follows.
Top edge portion → Bottom edge portion → Bevel portion
Bottom edge portion → Top edge portion → Bevel portion
Top edge portion →Bevel portion → Bottom edge portion
Bottom edge portion →- Bevel portion → Top edge portion
Bevel portion → Top edge portion → Bottom edge portion
Bevel portion → Bottom edge portion → Top edge portion

In addition to the above-described examples, it is also possible to polish only the top edge portion, only the bevel portion, or only the bottom edge portion. Further, it is also possible to polish the top edge portion or bottom edge portion and the bevel portion in desired sequences. In this manner, use of the pressing member 50 having the protrusions 51a and 51b and the pressing pad 70 enables the polishing tape 23 to polish not only the top edge portion and the bottom edge portion, but also the bevel portion.

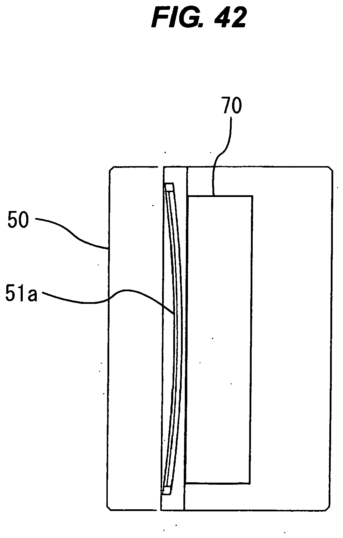

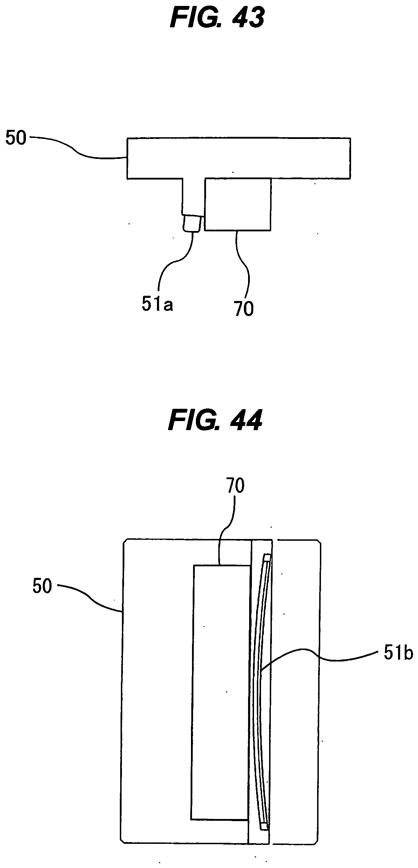

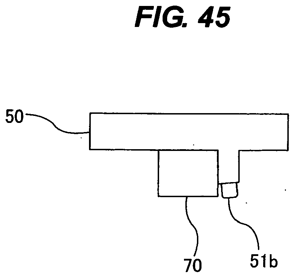

While the pressing pad 70 is disposed between the two protrusions 51a and 51b in the example shown in FIG 28, the pressing pad 70 may be applied to the pressing member 50 shown in FIG 19 through FIG 27. FIG 42 is a front view of the pressing member 50 having the pressing pad 70 that is adjacent to the protrusion 51a for pressing the top edge portion of the substrate. FIG 43 is a top view of the pressing member 50 shown in FIG 42. FIG. 44 is a front view of the pressing member 50 having the pressing pad 70 that is adjacent to the protrusion 51b for pressing the bottom edge portion of the substrate. FIG. 45 is a top view of the pressing member 50 shown in FIG 44. As shown in FIG 42 through FIG 45, the pressing pad 70 may be adjacent to the protrusion 51a or the protrusion 51b. The location and the shape of the pressing pad 70 in these examples are identical to those of the pressing pad 70 shown in FIG 28 through FIG 33.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but to the scope as defined by the appended claims.

## Claims

1. A polishing apparatus for polishing a peripheral portion of a substrate (W), said apparatus comprising:
a rotary holding mechanism (3) configured to hold the substrate (W) horizontally and to rotate the substrate (W); and
at least one polishing head (30) configured to be disposed near the peripheral portion of the substrate (W),
wherein said polishing head (30) has at least one protrusion (51a, 51b) for pressing a strip shaped polishing tool (23) against the peripheral portion of the substrate (W), and
wherein said polishing head (30) is configured to press a polishing surface of the strip-shaped polishing tool (23) by said protrusion against the peripheral portion of the substrate (W) from above or below, **characterised by** said protrusion (51a, 51b) having a circular arc shape extending along a circumferential direction of the substrate (W).

2. The polishing apparatus according to claim 1, further comprising:
at least one tilting mechanism (M4, 60, p3, p4, b2) configured to tilt said polishing head (30) with respect to a surface of the substrate (W),
wherein said at least one protrusion (51a, 51b) comprises a first protrusion (51a) and a second protrusion (51b) that are symmetrically arranged,
said first protrusion (51a) is located above the peripheral portion of the substrate (W) when the polishing head (30) is tilted upward, and
said second protrusion (51b) is located below the peripheral portion of the substrate (W) when the polishing head (30) is tilted downward.

3. The polishing apparatus according to claim 2, wherein:
said first protrusion (51a) is configured to press the polishing tool (23) against a top edge portion of the substrate (W); and
said second protrusion (51b) is configured to press the polishing tool (23) against a bottom edge portion of the substrate (W).

4. The polishing apparatus according to claim 2, wherein:
said at least one polishing head (30) comprises plural polishing heads (30) arranged around the substrate (W); and
said at least one tilting mechanism (M4, 60, p3, p4, b2) comprises plural tilting mechanisms (M4, 60, p3, p4, b2) configured to tilt said plural polishing heads (30) independently.

5. The polishing apparatus according to claim 2, wherein said polishing head (30) further has a pressing pad configured to press the polishing tool against the peripheral portion of the substrate (W), and said pressing pad (70) is disposed between said first protrusion (51a) and said second protrusion (51b).

6. The polishing apparatus according to claim 5, wherein a height of said pressing pad (70) is lower than a height of said first protrusion (51a) and said second protrusion (51b).

7. The polishing apparatus according to claim 1, wherein said polishing head (30) further has a pressing pad (70) configured to press the polishing tool (23) against the peripheral portion of the substrate (W), and said pressing pad (70) is adjacent to said at least one protrusion (51a, 51b).

8. The polishing apparatus according to claim 1, wherein a length of said at least one (51a, 51b) protrusion is longer than a width of the polishing tool (23).

9. The polishing apparatus according to claim 1, wherein:
said polishing head (30) includes two guide rollers (58a, 58b) configured to support the polishing surface of the polishing tool (23) and further includes an actuator (52) coupled to said two guide rollers (58a, 58b) and said at least one protrusion (51a, 51b);
said at least one protrusion (51a, 51b) is interposed between said two guide rollers (58a, 58b); and
said actuator (52) is configured to move said two guide rollers (58a, 58b) and said at least one protrusion (51a, 51b) in unison toward the peripheral portion of the substrate (W).

10. The polishing apparatus according to claim 1, wherein the strip-shaped polishing tool (23) is a polishing tape or a polishing cloth.

11. The polishing apparatus according to claim 1, further comprising:
a tilting mechanism (M4, 60, p3, p4, b2) configured to tilt said polishing head (30) with respect to a surface of the substrate (W),
wherein said at least one protrusion (51a, 51b) comprises a first protrusion (51a) and a second protrusion (51b) extending along a circumferential direction of the substrate (W),
wherein said polishing head (30) has a pressing pad (70) disposed between said first protrusion (51a) and said second protrusion (51b), and
wherein said polishing head (30) is configured to press the polishing surface of the strip-shaped polishing tool (23) by said first protrusion (51a) against the peripheral portion of the substrate (W) from above, to press the polishing surface of the polishing tool (23) by said second protrusion (51b) against the peripheral portion of the substrate (W) from below, and to press the polishing surface of the polishing tool (23) by said pressing pad (70) against the peripheral portion of the substrate (W).

12. A polishing method using said polishing apparatus according to claim 2, said method comprising:
rotating a substrate (W) by said rotary holding mechanism (3);
pressing the polishing tool (23) by said first protrusion (51a) against a peripheral portion of the substrate (W) from above to thereby polish a top edge portion of the substrate (W); and
pressing the polishing tool (23) by said second protrusion (51b) against the peripheral portion of the substrate (W) from below to thereby polish a bottom edge portion of the substrate (W).

13. The polishing method according to claim 12, further comprising:
before polishing the top edge portion, tilting said polishing head (30) upward by said tilting mechanism (M4, 60, p3, p4, b2); and
before polishing the bottom edge portion, tilting said polishing head (30) downward by said tilting mechanism (M4, 60, p3, p4, b2).

14. The polishing method according to claim 12, wherein the strip-shaped polishing tool (23) is a polishing tape or a polishing cloth.

15. A polishing method using said polishing apparatus according to claim 5, said method comprising:
rotating a substrate (W) by said rotary holding mechanism (3);
pressing the polishing tool (23) by said first protrusion (51a) against a peripheral portion of the substrate (W) from above to thereby polish a top edge portion of the substrate (W);
pressing the polishing tool by said second protrusion (51b) against the peripheral portion of the substrate (W) from below to thereby polish a bottom edge portion of the substrate (W); and
pressing the polishing tool by said pressing pad (70) against the peripheral portion of the substrate (W) to thereby polish a bevel portion of the substrate (W).

16. The polishing method according to claim 15, wherein said polishing of the bevel portion of the substrate includes pressing the polishing tool (23) against the peripheral portion of the substrate with said polishing head (30) tilted.

17. The polishing method according to claim 15, wherein the strip-shaped polishing tool (23) is a polishing tape or a polishing cloth.

18. A polishing method using said polishing apparatus according to claim 5, said method comprising:
rotating a substrate (W) by said rotary holding mechanism (3);
pressing a strip-shaped polishing tool (23) by a first polishing head (30) against a peripheral portion of the substrate (W) from above to thereby polish a top edge portion of the substrate (W);
pressing the strip-shaped polishing tool (23) by said first polishing head (30) against the peripheral portion of the substrate (W) from below to thereby polish a bottom edge portion of the substrate (W); and
during polishing of the bottom edge portion by said first polishing head (30), pressing a strip-shaped polishing tool (23) by a second polishing head (30) against the peripheral portion of the substrate (W) from above to thereby polish the top edge portion (W).

19. The polishing method according to claim 18, wherein the strip-shaped polishing tool (23) is a polishing tape or a polishing cloth.

20. A polishing method using said polishing apparatus according to claim 4, said method comprising:
rotating a substrate (W) by said rotary holding mechanism (3);
pressing a strip-shaped polishing tool (23) by a first polishing head (30) against a peripheral portion of the substrate (W) from above to thereby polish a top edge portion of the substrate (W); and
pressing a strip-shaped polishing tool (23) by a second polishing head (30) against the peripheral portion of the substrate (W) from below to thereby polish a bottom edge portion of the substrat (W)e.

21. The polishing method according to claim 20, wherein the strip-shaped polishing tool (23) is a polishing tape or a polishing cloth.

22. A pressing member for pressing a strip-shaped polishing tool (23) against a peripheral portion of a substrate (W), said pressing member comprising:
at least one protrusion (51a, 51b) for pressing the strip shaped polishing tool (23) against the peripheral portion of the substrate (W), **characterised by** said at least one protrusion (51a, 51b) having a circular arc shape extending along a circumferential direction of the substrate (W).

23. The pressing member according to claim 22, wherein:
said at least one protrusion (58a, 58b) comprises a first protrusion (51a) and a second protrusion (51b) that are arranged symmetrically;
said pressing member further comprises a pressing pad (70) that is configured to press the polishing tool (23) against the peripheral portion of the substrate (W); and
said pressing pad (70) is disposed between said first protrusion (51a) and said second protrusion (51b).

24. The pressing member according to claim 23, wherein a height of said pressing pad (70) is lower than a height of said first protrusion (51a) and said second protrusion (5 1b).

25. The pressing member according to claim 22, wherein the strip-shaped polishing tool (23) is a polishing tape or a polishing cloth.

## Patentansprüche

1. Eine Poliervorrichtung zum Polieren eines Randteils eines Substrats (W), wobei die Vorrichtung Folgendes aufweist:
einen drehbaren Haltemechanismus (3), der konfiguriert ist zum horizontalen Halten des Substrats (W) und zum Drehen des Substrats (W); und
mindestens einen Polierkopf (30), der konfiguriert ist, um in der Nähe des Randteils des Substrats (W) angeordnet zu sein,
wobei der Polierkopf (30) mindestens einen Vorsprung (51a, 51b) zum Drücken eines streifenförmigen Polierwerkzeuges (23) gegen den Randteil des Substrats (W) besitzt,
wobei der Polierkopf (30) konfiguriert ist zum Drücken einer Polieroberfläche des streifenförmigen Polierwerkzeuges (23) durch den Vorsprung von oben oder unten gegen den Randteil des Substrats (W), **dadurch gekennzeichnet, dass** der Vorsprung (51a, 51b) eine kreisförmige Bogenform besitzt, die sich entlang einer Umfangsrichtung des Substrats (W) erstreckt.

2. Poliervorrichtung nach Anspruch 1, die ferner Folgendes aufweist:
mindestens einen Kippmechanismus (M4, 60, p3, p4, b2), der konfiguriert ist zum Kippen des Polierkopfes (30) bezüglich einer Substratoberfläche (W),
wobei der mindestens eine Vorsprung (51a, 51b) einen ersten Vorsprung (51a) und einen zweiten Vorsprung (51b) aufweist, die symmetrisch angeordnet sind,
wobei der erste Vorsprung (51a) oberhalb des Randteils des Substrats (W) angeordnet ist, wenn der Polierkopf (30) aufwärts gekippt ist, und
wobei der zweite Vorsprung (51b) unterhalb des Randteils des Substrats (W) angeordnet ist, wenn der Polierkopf (30) abwärts gekippt ist.

3. Poliervorrichtung nach Anspruch 2, wobei
der erste Vorsprung (51a) konfiguriert ist zum Drücken des Polierwerkzeuges (23) gegen ein Oberkantenteil des Substrats (W); und
wobei der zweite Vorsprung (51b) konfiguriert ist zum Drücken des Polierwerkzeuges (23) gegen ein Unterkantenteil des Substrats (W).

4. Poliervorrichtung nach Anspruch 2, wobei:
mindestens ein Polierkopf (30) eine Vielzahl von Polierköpfen (30) aufweist, die um das Substrat (W) angeordnet sind; und
der mindestens eine Kippmechanismus (M4, 60, p3, p4, b2) eine Vielzahl von Kippmechanismen (M4, 60, p3, p4, b2) aufweist, die konfiguriert sind zum unabhängigen Kippen der Vielzahl von Polierköpfen (30).

5. Poliervorrichtung nach Anspruch 2, wobei der Polierkopf (30) ferner ein Druckkissen besitzt zum Drücken des Polierwerkzeuges gegen den Randteil des Substrats (W), und wobei das Druckkissen (70) zwischen dem ersten Vorsprung (51a) und dem zweiten Vorsprung (51b) angeordnet ist.

6. Poliervorrichtung nach Anspruch 5, wobei eine Höhe des Druckkissens (70) niedriger ist als eine Höhe des ersten Vorsprungs (51a) und des zweiten Vorsprungs (51b).

7. Poliervorrichtung nach Anspruch 1, wobei der Polierkopf (30) ferner ein Druckkissen (70) besitzt, das konfiguriert ist zum Drücken des Polierwerkzeuges (23) gegen den Randteil des Substrats (W), und wobei das Druckkissen (70) benachbart zu dem mindestens einen Vorsprung (51a, 51b) ist.

8. Poliervorrichtung nach Anspruch 1, wobei eine Länge des mindestens einen (51a, 51b) Vorsprungs länger ist als eine Breite des Polierwerkzeuges (23).

9. Poliervorrichtung nach Anspruch 1, wobei:
der Polierkopf (30) zwei Führungsrollen (58a, 58b) aufweist, die konfiguriert sind zum Tragen der Polieroberfläche des Polierwerkzeuges (23) und ferner ein Betätiger (52) aufweist, der mit den zwei Führungsrollen (58a, 58b) und dem mindestens einen Vorsprung (51a, 51b) gekoppelt ist;
wobei der mindestens eine Vorsprung (51a, 51b) zwischen den zwei Führungsrollen (58a, 58b) angeordnet ist; und
wobei der Betätiger (52) konfiguriert ist zum gemeinsamen Bewegen der zwei Führungsrollen (58a, 58b) und dem mindestens einen Vorsprung (51a, 51b) zu dem Randteil des Substrats (W).

10. Poliervorrichtung nach Anspruch 1, wobei das streifenförmige Polierwerkzeug (23) ein Polierband oder ein Poliertuch ist.

11. Poliervorrichtung nach Anspruch 1, die ferner Folgendes aufweist:
Einen Kippmechanismus (M4, 60, p3, p4, b2), der konfiguriert ist zum Koppen des Polierkopfes (30) bezüglich einer Substratoberfläche (W),
wobei der mindestens eine Vorsprung (51a, 51b) einen ersten Vorsprung (51a) und einen zweiten Vorsprung (51b) aufweist, der sich entlang einer Umfangsrichtung des Substrats (W) erstreckt,
wobei der Polierkopf (30) ein Druckkissen (70) besitzt, das zwischen dem ersten Vorsprung (51a) und dem zweiten Vorsprung (51b) angeordnet ist, und
wobei der Polierkopf (30) konfiguriert ist zum Drücken der Polieroberfläche des streifenförmigen Polierwerkzeuges (23) durch den ersten Vorsprung (51a) von oben gegen den Randteil des Substrats (W), zum Drücken der Polieroberfläche des Polierwerkzeuges (23) durch den zweiten Vorsprung (51b) von unten gegen den Randteil des Substrats (W) und zum Drücken der Polieroberfläche des Polierwerkzeuges (23) durch das Druckkissen (70) gegen den Randteil des Substrats (W).

12. Polierverfahren, das die Poliervorrichtung nach Anspruch 2 verwendet, wobei das Verfahren Folgendes aufweist:
Drehen eines Substrats (W) durch den drehbaren Haltemechanismus (3);
Drücken des Polierwerkzeuges (23) durch den ersten Vorsprung (51a) von oben gegen ein Randteil des Substrats (W), um dadurch ein Oberkantenteil des Substrats (W) zu polieren; und
Drücken des Polierwerkzeuges (23) durch den zweiten Vorsprung (51b) von unten gegen ein Randteil des Substrats (W), um dadurch ein Unterkantenteil des Substrats (W) zu polieren.

13. Polierverfahren nach Anspruch 12, das ferner Folgendes aufweist:
vor dem Polieren des Oberkantenteils, Aufwärtskippen des Polierkopfes (30) durch den Kippmechanismus (M4, 60, p3, p4, b2); und
vor dem Polieren des Unterkantenteils, Abwärtskippen des Polierkopfes (30) durch den Kippmechanismus (M4, 60, p3, p4, b2).

14. Polierverfahren nach Anspruch 12, wobei das streifenförmige Polierwerkzeug (23) ein Polierband oder ein Poliertuch ist.

15. Polierverfahren, das die Poliervorrichtung nach Anspruch 5 verwendet, wobei das Verfahren Folgendes aufweist:
Drehen eines Substrats (W) durch den drehbaren Haltemechanismus (3);
Drücken des Polierwerkzeuges (23) durch den ersten Vorsprung (51a) von oben gegen ein Randteil des Substrats (W), um dadurch ein Oberkantenteil des Substrats (W) zu polieren;
Drücken des Polierwerkzeuges durch den zweiten Vorsprung (51b) von unten gegen ein Randteil des Substrats (W), um dadurch ein Unterkantenteil des Substrats (W) zu polieren; und
Drücken des Polierwerkzeuges durch das Druckkissen (70) gegen den Randteil des Substrats (W), um dadurch ein Schrägteil bzw. Bevelteil des Substrats (W) zu polieren.

16. Polierverfahren nach Anspruch 15, wobei das Polieren des Schrägteils des Substrats das Drücken des Polierwerkzeuges (23) gegen den Randteil des Substrats mit dem gekippten Polierkopf (30) aufweist.

17. Polierverfahren nach Anspruch 15, wobei das streifenförmige Polierwerkzeug (23) ein Polierband oder ein Poliertuch ist.

18. Polierverfahren, das die Poliervorrichtung nach Anspruch 5 verwendet, wobei das Verfahren Folgendes aufweist:
Drehen eines Substrats (W) durch den Haltemechanismus (3);
Drücken des streifenförmigen Polierwerkzeuges (23) durch einen ersten Polierkopf (30) von oben gegen ein Randteil des Substrats (W), um dadurch ein Oberkantenteil des Substrats (W) zu polieren;
Drücken des streifenförmigen Polierwerkzeuges (23) durch den ersten Polierkopf (30) von unten gegen den Randteil des Substrats (W), um dadurch ein Unterkantenteil des Substrats (W) zu polieren; und
während des Polierens des Unterkantenteils durch den ersten Polierkopf (30), Drücken eines streifenförmigen Polierwerkzeuges (23) durch einen zweiten Polierkopf (30) von oben gegen den Randteil des Substrats (W), um dadurch das Oberkantenteil (W) zu polieren.

19. Polierverfahren nach Anspruch 18, wobei das streifenförmige Polierwerkzeug (23) ein Polierband oder Poliertuch ist.

20. Polierverfahren, das die Poliervorrichtung nach Anspruch 4 verwendet, wobei das Verfahren Folgendes aufweist:
Drehen eines Substrats (W) durch den drehbaren Haltemechanismus (3);
Drücken eines streifenförmigen Polierwerkzeuges (23) durch einen ersten Polierkopf (30) von oben gegen ein Randteil des Substrats (W), um dadurch ein Oberkantenteil des Substrats (W) zu polieren; und
Drücken eines streifenförmigen Polierwerkzeuges (23) durch einen zweiten Polierkopf (30) von unten gegen ein Randteil des Substrats (W), um dadurch ein Unterkantenteil des Substrats (W) zu polieren.

21. Polierverfahren nach Anspruch 20, wobei das streifenförmige Polierwerkzeug (23) ein Polierband oder Poliertuch ist.

22. Ein Druckglied zum Drücken eines streifenförmigen Polierwerkzeuges (23) gegen einen Randteil eines Substrats (W), wobei das Druckglied Folgendes aufweist:
mindestens einen Vorsprung (51a, 51b) zum Drücken des streifenförmigen Polierwerkzeuges (23) gegen den Randteil des Substrats (W), **dadurch gekennzeichnet, dass**
der mindestens eine Vorsprung (51a, 51b) eine kreisförmige Bogenform besitzt, die sich entlang einer Umfangsrichtung des Substrats (W) erstreckt.

23. Druckglied nach Anspruch 22, wobei:
der mindestens eine Vorsprung (58a, 58b) einen ersten Vorsprung (51a) und einen zweiten Vorsprung (51b) aufweist, die symmetrisch angeordnet sind;
wobei das Druckglied ein Druckkissen (70) aufweist, das konfiguriert ist zum Drücken des Polierwerkzeuges (23) gegen den Randteil des Substrats (W); und
wobei das Druckkissen (70) zwischen dem ersten Vorsprung (51a) und dem zweiten Vorsprung (51b) angeordnet ist.

24. Druckglied nach Anspruch 23, wobei die Höhe des Druckkissens (70) niedriger ist als eine Höhe des ersten Vorsprungs (51a) und des zweiten Vorsprungs (51b).

25. Druckglied nach Anspruch 22, wobei das streifenförmige Polierwerkzeug (23) ein Polierband oder Poliertuch ist.

## Revendications

1. Appareil de polissage pour polir une portion périphérique d'un substrat (W), l'appareil comprenant :
un mécanisme de maintien rotatif (3) agencé pour tenir le substrat (W) horizontalement et pour faire tourner le substrat (W) ; et
au moins une tête de polissage (30) agencée pour être disposée près de la portion périphérique du substrat (W),
dans lequel la tête de polissage (30) comporte au moins une protubérance (51a, 51b) pour presser un outil de polissage en forme de bande (23) contre la portion périphérique du substrat (W),
et
dans lequel la tête de polissage (30) est agencée pour presser une surface de polissage de l'outil de polissage en forme de bande (23) par la protubérance contre la portion périphérique du substrat (W) à partir du dessus ou du dessous, **caractérisé en ce que** la protubérance (51a, 51b) a une forme en arc circulaire s'étendant lelong d'une direction circonférentielle du substrat (W).

2. Appareil de polissage selon la revendication 1, comprenant en outre :
au moins un mécanisme d'inclinaison (M4, 60, p3, p4, b2) agencé pour incliner la tête de polissage (30) par rapport à une surface du substrat (W),
dans lequel ladite au moins une protubérance (51a, 51b) comprend une première protubérance (51a) et une deuxième protubérance (51b) qui sont disposées de manière symétrique,
lapremière protubérance (51a) est située au-dessus de la portion périphérique du substrat (W) lorsque la tête de polissage (30) est inclinée vers le haut, et
ladeuxième protubérance (51b) est située en dessous de la portion périphérique du substrat (W) lorsque la tête de polissage (30) est inclinée vers le bas.

3. Appareil de polissage selon la revendication 2, dans lequel :
lapremière protubérance (51a) est agencée pour presser l'outil de polissage (23) contre une portion de bord supérieur du substrat (W) ; et
ladeuxième protubérance (51b) est agencée pour presser l'outil de polissage (23) contre une portion de bord inférieur du substrat (W).

4. Appareil de polissage selon la revendication 2, dans lequel :
ladite au moins une tête de polissage (30) comprend plusieurs têtes de polissage (30) agencées autour du substrat (W) ; et
ledit au moins un mécanisme d'inclinaison (M4, 60, p3, p4, b2) comprend plusieurs mécanismes d'inclinaison (M4, 60, p3, p4, b2) agencés pour incliner la pluralité de têtes de polissage (30) de manière indépendante.

5. Appareil de polissage selon la revendication 2, dans lequel la tête de polissage (30) comprend en outre un patin de pression agencé pour presser l'outil de polissage contre la portion périphérique du substrat (W), et le patin de pression (70) est disposé entre la première protubérance (51a) et la deuxième protubérance (51b).

6. Appareil de polissage selon la revendication 5, dans lequel une hauteur du patin de pression (70) est inférieure à une hauteur de la première protubérance (51a) et de la deuxième protubérance (51b).

7. Appareil de polissage selon la revendication 1, dans lequel la tête de polissage (30) comporte en outre un patin de pression (70) agencé pour presser l'outil de polissage (23) contre la portion périphérique du substrat (W), et le patin de pression (70) est adjacent à ladite au moins une protubérance (51a, 51b).

8. Appareil de polissage selon la revendication 1, dans lequel la longueur de ladite au moins une protubérance (51a, 51b) est plus longue que la largeur de l'outil de polissage (23).

9. Appareil de polissage selon la revendication 1, dans lequel :
la tête de polissage (30) comprend deux rouleaux de guidage (58a, 58b) agencés pour supporter la surface de polissage de l'outil de polissage (23) et comprend en outre un actionneur (52) couplé aux deux rouleaux de guidage (58a, 58b) et à ladite au moins une protubérance (51a, 51b) ;
ladite au moins une protubérance (51a, 51b) est interposée entre les deux rouleaux de guidage (58a, 58b) ; et
l'actionneur (52) est agencé pour déplacer les deux rouleaux de guidage (58a, 58b) et ladite au moins une protubérance (51a, 51b) à l'unisson en direction de la portion périphérique du substrat (W).

10. Appareil de polissage selon la revendication 1, dans lequel l'outil de polissage en forme de bande (23) est une bande de polissage ou un tissu de polissage.

11. Appareil de polissage selon la revendication 1, comprenant en outre :
un mécanisme d'inclinaison (M4, 60, p3, p4, b2) agencé pour incliner la tête de polissage (30) par rapport à une surface du substrat (W),
dans lequel ladite au moins une protubérance (51a, 51b) comprend une première protubérance (51a) et une deuxième protubérance (51b) s'étendant suivant une direction circonférentielle du substrat (W),
dans lequel la tête de polissage (30) comporte un patin de pression (70) disposé entre la première protubérance (51a) et la deuxième protubérance (51b), et
dans lequel la tête de polissage (30) est agencée pour presser la surface de polissage de l'outil de polissage en forme de bande (23) par la première protubérance (51a) contre la portion périphérique du substrat (W) à partir du dessus, pour presser la surface de polissage de l'outil de polissage (23) par la deuxième protubérance (51b) contre la portion périphérique du substrat (W) à partir du dessous, et pour presser la surface de polissage de l'outil de polissage (23) par le patin de pression (70) contre la portion périphérique du substrat (W).

12. Procédé de polissage utilisant l'appareil de polissage selon la revendication 2, le procédé comprenant :
faire tourner un substrat (W) par le mécanisme de maintien rotatif (3) ;
presser l'outil de polissage (23) par la première protubérance (51a) contre une portion périphérique du substrat (W) à partir du dessus pour polir ainsi une portion de bord supérieur du substrat (W) ; et
presser l'outil de polissage (23) par la deuxième protubérance (51b) contre la portion périphérique du substrat (W) à partir du dessous pour polir ainsi une portion de bord inférieur du substrat (W).

13. Procédé de polissage selon la revendication 12, comprenant en outre :
avant de polir la portion de bord supérieur, incliner la tête de polissage (30) vers le haut par le mécanisme d'inclinaison (M4, 60, p3, p4, b2) ; et
avant de polir la portion de bord inférieur, incliner la tête de polissage (30) vers le bas par le mécanisme d'inclinaison (M4, 60, p3, p4, b2).

14. Procédé de polissage selon la revendication 12, dans lequel l'outil de polissage en forme de bande (23) est une bande de polissage ou un tissu de polissage.

15. Procédé de polissage utilisant l'appareil de polissage selon la revendication 5, le procédé comprenant :
faire tourner un substrat (W) par le mécanisme de maintien rotatif (3) ;
presser l'outil de polissage (23) par la première protubérance (51a) contre une portion périphérique du substrat (W) à partir du dessus pour polir ainsi une portion de bord supérieur du substrat (W) ;
presser l'outil de polissage par la deuxième protubérance (51b) contre la portion périphérique du substrat (W) à partir du dessous pour polir ainsi une portion de bord inférieur du substrat (W) ; et
presser l'outil de polissage par le patin de pression (70) contre la portion périphérique du substrat (W) pour polir ainsi une portion de chanfrein du substrat (W).

16. Procédé de polissage selon la revendication 15, dans lequel le polissage de la portion dechanfrein du substrat comprend de presser l'outil de polissage (23) contre la portion périphérique du substrat avec la tête de polissage (30) inclinée.

17. Procédé de polissage selon la revendication 15, dans lequel l'outil de polissage en forme de bande (23) est une bande de polissage ou un tissu de polissage.

18. Procédé de polissage utilisant l'appareil de polissage selon la revendication 5, dans lequel le procédé comprend :
faire tourner un substrat (W) par le mécanisme de maintien rotatif (3) ;
presser un outil de polissage en forme de bande (23) par une première tête de polissage (30) contre une portion périphérique du substrat (W) à partir du dessus pour polir ainsi une portion de bord supérieur du substrat (W) ;
presser l'outil de polissage en forme de bande (23) par la première tête de polissage (30) contre la portion périphérique du substrat (W) à partir du dessous pour polir ainsi une portion de bord inférieur du substrat (W) ; et
pendant le polissage de la portion de bord inférieur par la première tête de polissage (30), presser un outil de polissage en forme de bande (23) par une deuxième tête de polissage (30) contre la portion périphérique du substrat (W) à partir du dessus pour polir ainsi la portion de bord supérieur (W) .

19. Procédé de polissage selon la revendication 18, dans lequel l'outil de polissage en forme de bande (23) est une bande de polissage ou un tissu de polissage.

20. Procédé de polissage utilisant l'appareil de polissage selon la revendication 4, le procédé comprenant :
faire tourner un substrat (W) par le mécanisme de maintien rotatif (3) ;
presser un outil de polissage en forme de bande (23) par une première tête de polissage (30) contre une portion périphérique du substrat (W) à partir du dessus pour polir ainsi une portion de bord supérieur du substrat (W) ; et
presser un outil de polissage en forme de bande (23) par une deuxième tête de polissage (30) contre la portion périphérique du substrat (W) à partir du dessous pour polir ainsi une portion de bord inférieur de substrat (W)e.

21. Procédé de polissage selon la revendication 20, dans lequel l'outil de polissage en forme de bande (23) est une bande de polissage ou un tissu de polissage.

22. Élément de pression pour presser un outil de polissage en forme de bande (23) contre une portion périphérique d'un substrat (W), l'élément de pression comprenant :
au moins une protubérance (51a, 51b) pour presser l'outil de polissage en forme de bande (23) contre la portion périphérique du substrat (W), **caractérisé en ce que** ladite au moins une protubérance (51a, 51b) a une forme d'arc circulaire s'étendant suivant une direction circonférentielle du substrat (W) .

23. Élément de pression selon la revendication 22, dans lequel :
ladite au moins une protubérance (58a, 58b) comprend une première protubérance (51a) et une deuxième protubérance (51b) qui sont agencées de manière symétrique ;
l'élément de pression comprend en outre un patin de pression (70) qui est agencé pour presser l'outil de polissage (23) contre la portion périphérique du substrat (W) ; et
lepatin de pression (70) est disposé entre la première protubérance (51a) et la deuxième protubérance (51b).

24. Élément de pression selon la revendication 23, dans lequel la hauteur du patin de pression (70) est inférieure à une hauteur de la première protubérance (51a) et de la deuxième protubérance (51b).

25. Élément de pression selon la revendication 22, dans lequel l'outil de polissage en forme de bande (23) est une bande de polissage ou un tissu de polissage.
